(19) Europäisches Patentamt
European Patent Office
Office européen des brevets

(11) EP 4 180 148 A1

(12) EUROPEAN PATENT APPLICATION
published in accordance with Art. 153(4) EPC

(43) Date of publication:
**17.05.2023 Bulletin 2023/20**

(21) Application number: **21837005.4**

(22) Date of filing: **05.07.2021**

(51) International Patent Classification (IPC):
***B22F 1/00*** (2022.01) ***B22F 7/04*** (2006.01)
***B82Y 40/00*** (2011.01) ***B33Y 10/00*** (2015.01)
***H01B 13/00*** (2006.01) ***B29C 64/112*** (2017.01)
***H05K 1/09*** (2006.01) ***H05K 3/10*** (2006.01)
***H05K 3/12*** (2006.01) ***H05K 3/28*** (2006.01)
***B22F 3/16*** (2006.01)

(52) Cooperative Patent Classification (CPC):
**B22F 1/00; B22F 3/16; B22F 7/04; B29C 64/112; B33Y 10/00; B82Y 40/00; H01B 13/00; H05K 1/09; H05K 3/10; H05K 3/12; H05K 3/28**

(86) International application number:
**PCT/JP2021/025307**

(87) International publication number:
**WO 2022/009839 (13.01.2022 Gazette 2022/02)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **08.07.2020 JP 2020118060**

(71) Applicant: **Daicel Corporation**
**Osaka 530-0011 (JP)**

(72) Inventor: **ITO, Yousuke**
**Tokyo 108-8230 (JP)**

(74) Representative: **Grünecker Patent- und Rechtsanwälte PartG mbB**
**Leopoldstraße 4**
**80802 München (DE)**

# (54) METHOD FOR MANUFACTURING ELECTROCONDUCTIVE LAMINATE

(57) An object of the present disclosure is to provide a method for manufacturing a conductive laminate having an excellent steady contact between a conductive layer and an overcoat layer. The present disclosure provides a method for manufacturing a conductive laminate 10 including a substrate 11, a conductive layer 12, and an overcoat layer 13 being laminated, the method including the following Steps: Step A: forming the conductive layer 12 on the substrate 11 using a conductive ink containing a metal nanoparticle and a first ink resin; and Step B: forming the overcoat layer 13 on the conductive layer 12 using an overcoat layer-forming composition, the overcoat layer-forming composition containing an overcoat layer resin and an overcoat layer solvent, the overcoat layer solvent having an SP value, where a difference between the SP value and an SP value of the first ink resin is 1.0 or less in absolute value.

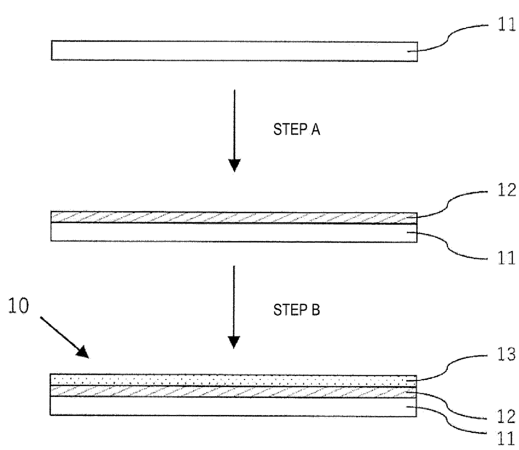


FIG. 1

EP 4 180 148 A1

## Description

### Technical Field

The present disclosure relates to a method for manufacturing a conductive laminate. More specifically, the present disclosure relates to a method for manufacturing a conductive laminate in which a substrate, a conductive layer, and an overcoat layer are laminated. The present application claims priority from the Japanese Patent Application No. 2020-118060, filed in Japan on July 8, 2020, the contents of which are incorporated herein by reference.

### Background Art

An electronic device (for example, an electronic circuit) including a conductive layer such as an electrode or a wire has been formed by an etching method or the like. However, there have been issues of complicated processes and increased cost. Therefore, a method of directly forming an electronic device by printing has been studied as an alternative method.

Among metals, bulk silver has a high melting point of 962°C, but nano-sized silver particles (silver nanoparticles) fuse together at a temperature of approximately 100°C. Thus, use of silver nanoparticles can form a conductive layer with excellent electrical conductivity on a general-purpose plastic substrate with low heat resistance. However, nano-sized metal particles are problematically prone to agglomeration.

Patent Document 1 discloses that coating surfaces of silver nanoparticles with amines can suppress agglomeration of the silver nanoparticles; that a conductive ink obtained by dispersing the silver nanoparticles whose surfaces are coated with amines in a dispersion medium is excellent in dispersion stability of the silver nanoparticles and can be suitably used in applications to directly form, on a substrate, a conductive layer by a printing method; and that sintering the conductive ink can provide a sintered body with excellent electrical conductivity.

Additionally, Patent Documents 2 to 4 disclose, for example, coating a metal layer, such as a conductive layer formed on a substrate, with an overcoat layer formed from a resin such as a urethane acrylate for the purpose of protecting the metal layer from degradation due to oxygen, moisture, and the like in air or from an external impact.

### Citation List

#### Patent Document

Patent Document 1: WO 2014/021270

Patent Document 2: JP 2019-098683 A

Patent Document 3: JP 2020-049813 A

Patent Document 4: JP 2018-206697 A

### Summary of Invention

#### Technical Problem

However, due to a low steady contact between a conductive layer formed of a metal and an overcoat layer formed of a resin, floating or peeling of the overcoat layer may occur, resulting in a failure such as degradation of the conductive layer.

Accordingly, an object of the present disclosure is to provide a method for manufacturing a conductive laminate having an excellent steady contact between a conductive layer and an overcoat layer.

#### Solution to Problem

As a result of diligent research to solve the above-described issues, the inventors of the present disclosure have found that, when a conductive laminate is manufactured by applying an overcoat layer-forming composition containing an overcoat layer resin and an overcoat layer solvent to a conductive layer formed on a substrate using a conductive ink containing metal nanoparticles and an ink resin, a steady contact between the conductive layer and the

overcoat layer is improved by controlling a difference between an SP value of the ink resin and an SP value of the overcoat layer solvent. The invention of the present disclosure was completed based on these findings.

In the present specification, the "nanoparticle(s)" means particles having a primary particle size (average primary particle size) of 0.1 nm or greater and less than 1000 nm. The particle size is determined by dynamic light scattering. Furthermore, the boiling point in the present specification is a value under normal pressure (760 mmHg).

That is, the present disclosure provides a method for manufacturing a conductive laminate, the conductive laminate including a substrate, a conductive layer, and an overcoat layer being laminated, the method including the following Steps:

Step A: forming the conductive layer on the substrate using a conductive ink containing a metal nanoparticle and a first ink resin; and

Step B: forming the overcoat layer on the conductive layer using an overcoat layer-forming composition, the overcoat layer-forming composition including an overcoat layer resin and an overcoat layer solvent, the overcoat layer solvent having an SP value, where a difference between the SP value and an SP value of the first ink resin being 1.0 or less in absolute value.

In the method for manufacturing a conductive laminate, the metal nanoparticle is preferably a surface-modified metal nanoparticle having a configuration in which a surface of a metal nanoparticle is coated with an organic protective agent.

In the method for manufacturing a conductive laminate, the organic protective agent is preferably a compound having at least one type of functional group selected from the group consisting of a carboxyl group, a hydroxyl group, an amino group, a sulfo group, and a thiol group.

In the method for manufacturing a conductive laminate, the metal nanoparticle is preferably a silver nanoparticle.

In the method for manufacturing a conductive laminate, the conductive ink may further contain a binder resin.

In the method for manufacturing a conductive laminate, a content of the first ink resin in the conductive ink is preferably from 0.01 to 10 wt.%.

In the method for manufacturing a conductive laminate, a content of the overcoat layer solvent in the overcoat layer-forming composition is preferably from 50 to 90 wt.%.

In the method for manufacturing a conductive laminate, the first ink resin preferably contains a thermoplastic resin.

In the method for manufacturing a conductive laminate, the overcoat layer resin preferably contains at least one selected from the group consisting of a thermoplastic resin, a heat curable resin, and an ultraviolet curable resin.

In the method for manufacturing a conductive laminate, Step A preferably includes applying the conductive ink onto the substrate by a printing method, and sintering the conductive ink.

The method for manufacturing a conductive laminate may further include the following Step:
Step C: forming a hardcoat layer on the overcoat layer.

## Advantageous Effects of Invention

The method of the present disclosure makes it possible to manufacture a conductive laminate having excellent steady contact between the conductive layer and the overcoat layer. Accordingly, an electronic device including the conductive laminate manufactured by the method of the present disclosure is less likely to cause a failure due to floating or peeling of the overcoat layer, and has excellent durability and quality.

## Brief Description of Drawings

FIG. 1 is a schematic view illustrating a method for manufacturing a conductive laminate of the present disclosure.

## Description of Embodiments

### Method for manufacturing conductive laminate

The method for manufacturing a conductive laminate of the present disclosure is a method for manufacturing a conductive laminate, in which a substrate, a conductive layer, and an overcoat layer are laminated, and the method includes the following Steps:

Step A: forming the conductive layer on the substrate using a conductive ink containing a metal nanoparticle and a first ink resin; and

Step B: forming the overcoat layer on the conductive layer using an overcoat layer-forming composition, the overcoat layer-forming composition containing an overcoat layer resin and an overcoat layer solvent, the overcoat layer solvent having an SP value, where a difference between the SP value and an SP value of the first ink resin is 1.0 or less in absolute value.

FIG. 1 is a schematic view illustrating the method for manufacturing a conductive laminate of the present disclosure. Reference numeral 10 denotes a conductive laminate; 11 denotes a substrate; 12 denotes a conductive layer; and 13 denotes an overcoat layer.

The absolute value of the difference between the SP value of the first ink resin used in Step A and the SP value of the overcoat layer solvent used in Step B is 1.0 or less, thereby greatly improving the steady contact between the conductive layer and the overcoat layer. The reason why the steady contact between the conductive layer and the overcoat layer is improved by setting the absolute value of the difference between the SP values to 1.0 or less is not clear, but is considered as follows by the inventors of the present disclosure.

That is, it is considered that, when the overcoat layer solvent contained in the overcoat layer-forming composition is brought into contact with the conductive layer formed in Step A, the first ink resin present near a contact surface (i.e., a surface of the conductive layer) is eluted by the overcoat layer solvent, and that a fine porous structure is formed near the surface of the conductive layer. It is considered that the overcoat layer resin enters pores of the thus-formed porous structure, and is dried and/or cured, thereby providing an anchoring effect and improving the steady contact.

In general, when a solute and a solvent have close SP values, the solute is known to have excellent solubility in the solvent. Therefore, it is considered that, due to the use of an overcoat layer solvent having an SP value close to the SP value of the first ink resin, the first ink resin present near the surface of the conductive layer is easily dissolved in the overcoat layer solvent, resulting in formation of a fine and deep porous structure, enhancement of the above-described anchoring effect, and further improvement of the steady contact. Note that this mechanism of action is presumptive, and is not to be construed as limiting the invention of the present disclosure.

The absolute value of the difference between the SP value of the first ink resin and the SP value of the overcoat layer solvent is not particularly limited, as long as it is 1.0 or less, but is preferably 0.9 or less, more preferably 0.8 or less, even more preferably 0.7 or less, even more preferably 0.6 or less, even more preferably 0.5 or less, even more preferably 0.4 or less, even more preferably 0.3 or less, even more preferably 0.2 or less, and even more preferably 0.1 or less, from the perspective of further improving the steady contact. The absolute value of the difference between the SP values is preferably small, and a lower limit thereof is not limited, i.e., is most preferably 0.

The SP values of the first ink resin and the overcoat layer solvent are not particularly limited, but, in an embodiment of the present disclosure, are SP values according to a Fedors method. The SP values according to the Fedors method are expressed as a square root of a ratio of an agglomeration energy density (ΔE) to a molecular volume (V) represented by the following formula.

$$SP^2 = \Delta E/V$$

A calculation method for SP values is described in Polymer Engineering and Science (authored by Robert F. Fadors et al.), Vol. 14, pp. 151-154.

Substrate

The substrate used in the method according to an embodiment of the present disclosure is not particularly limited, but a glass substrate, a heat resistant plastic substrate with high heat resistance, or a general-purpose plastic substrate with low heat resistance can be used. For example, a polyimide-based film can be used as the heat resistant plastic substrate. Also, for example, a polyester-based film (e.g., a polyethylene terephthalate (PET) film or a polyethylene naphthalate (PEN) film) or a polyolefin-based film (e.g., a polypropylene) can be used as the general-purpose plastic substrate.

Conductive ink

The conductive ink in an embodiment of the present disclosure contains metal nanoparticles and a first ink resin. In addition to these components, the conductive ink can contain an additive such as a dispersion medium, a binder resin (second ink resin), a surface energy adjusting agent, a plasticizer, a leveling agent, or an antifoaming agent as necessary.

Metal nanoparticles

The metal nanoparticles according to an embodiment of the present disclosure are not particularly limited, as long as a size of primary particles (average primary particle size) is less than 1000 nm, but are preferably surface-modified metal nanoparticles having a configuration in which surfaces of the metal nanoparticles are coated with an organic protective agent (hereinafter, simply referred to as "surface-modified metal nanoparticles" in some cases), from the perspectives that the agglomeration of the metal nanoparticles can be suppressed and that their dispersibility can be improved. The surface-modified metal nanoparticles according to an embodiment of the present disclosure have excellent dispersibility because the spacing between the metal nanoparticles is ensured and thus agglomeration is suppressed.

The surface-modified metal nanoparticles include a metal nanoparticle portion and a surface modification portion that coats the metal nanoparticle portion (i.e., the portion that coats the metal nanoparticles and is formed of an organic protective agent), and the proportion of the surface modification portion is, for example, approximately from 1 to 20 wt.% (preferably from 1 to 10 wt.%) of the weight of the metal nanoparticle portion. Each weight of the metal nanoparticle portion and the surface modification portion in the surface-modified metal nanoparticles can be determined, for example, from the weight loss rate in a certain temperature range by subjecting the surface-modified metal nanoparticles to thermogravimetry.

The average primary particle size of the metal nanoparticle portion in the surface-modified metal nanoparticles is, for example, from 0.5 to 100 nm, preferably from 0.5 to 80 nm, more preferably from 1 to 70 nm, and even more preferably from 1 to 60 nm. The average primary particle size is determined from particle sizes of 10 silver nanoparticles optionally selected in an SEM photograph obtained by observation with a scanning electron microscope as will be described in the Examples (JSM-6700F available from JEOL Ltd.).

The metal constituting the metal nanoparticles can be a metal having electrical conductivity, and examples thereof include gold, silver, copper, nickel, aluminum, rhodium, cobalt, and ruthenium. Among them, silver nanoparticles are preferred as the metal nanoparticles according to an embodiment of the present disclosure in that the silver nanoparticles are fused to each other at a temperature of approximately 100°C, and can form a wire having excellent electrical conductivity even on a general-purpose plastic substrate with low heat resistance. Accordingly, the metal nanoparticles according to an embodiment of the present disclosure are preferably silver nanoparticles, and more preferably surface-modified silver nanoparticles. That is, the conductive ink according to an embodiment of the present disclosure is preferably a silver ink.

The organic protective agent that constitutes the surface modification portion of the surface-modified metal nanoparticles is preferably a compound having at least one type of functional group selected from the group consisting of a carboxyl group, a hydroxyl group, an amino group, a sulfo group, and a thiol group, particularly preferably a compound having from 4 to 18 carbon atoms and having at least one type of functional group selected from the group consisting of an amino group, a sulfo group, and a thiol group, most preferably a compound having at least an amino group, and especially preferably a compound having from 4 to 18 carbon atoms and having an amino group (i.e., an amine having from 4 to 18 carbon atoms).

As the surface-modified metal nanoparticles, for example, the surface-modified silver nanoparticles can be manufactured by the manufacturing method described below.

First ink resin

The first ink resin according to an embodiment of the present disclosure is not particularly limited, as long as it has solubility in the overcoat layer solvent described below, but is preferably a thermoplastic resin. Examples of the thermoplastic resin include Teflon (trade name), fluororubber, silicone rubber, polyisobutylene, butyl rubber, ethylene propylene rubber, polyethylene, polypropylene, chlorosulfonated polyethylene, natural rubber, isoprene rubber, butadiene rubber, styrene butadiene rubber, polystyrene, petroleum hydrocarbon resin, chloroprene rubber, nitrile rubber, polymethyl methacrylate, polysulfide rubber, chloride rubber, polyvinyl acetate, acrylic rubber, polyvinyl chloride, urethane rubber, polyethylene terephthalate, polybutylene terephthalate, epoxy resin, phenol resin, alkyd resin, polyvinylidene chloride, polyvinyl alcohol, polyamide, polyether, polyimide, and cellulose. One of the first ink resins can be contained alone or two or more in combination.

The first ink resin according to an embodiment of the present disclosure can be an ink resin having an SP value of preferably approximately from 7 to 14, and more preferably approximately from 8 to 13, from the perspective of solubility in the overcoat layer solvent described below, the steady contact between the conductive layer and the substrate, and the like. Specific suitable examples of the first ink resin according to an embodiment of the present disclosure include Isoprene rubber (SP value: 8.13), polymethyl methacrylate (SP value: 9.5), polyvinyl acetate (SP value: 9.6), urethane rubber (SP value: 10), polyethylene terephthalate (SP value : 10.7), epoxy resin (SP value: 10.9), polyester urethane (SP value: 12), and polyvinyl alcohol (SP value: 12.6).

Dispersion medium

The conductive ink according to an embodiment of the present disclosure preferably contains a dispersion medium for dispersing the metal nanoparticles.
Examples of the dispersion medium include alcohols (b-1) and hydrocarbons (b-2). One of the alcohols (b-1) and the hydrocarbons (b-2) can be contained alone or two or more in combination. The alcohol (b-1) and the hydrocarbon (b-2) each alone may be a liquid or solid under normal temperature and normal pressure, but the dispersion medium containing these components together is a dispersion medium in a liquid state (a liquid dispersion medium) under normal temperature and normal pressure.
When the alcohol (b-1) and the hydrocarbon (b-2) are contained in combination as the dispersion medium, excellent dispersibility and dispersion stability of the surface-modified metal nanoparticles are obtained.

Alcohol (b-1)

The alcohol (b-1) includes primary alcohols, secondary alcohols, and tertiary alcohols. In an embodiment of the present disclosure, among them, the secondary alcohol and/or the tertiary alcohol are/is particularly preferred in that they can stably maintain the dispersibility of the surface-modified metal nanoparticles for a long period of time because they have low reactivity with the surface modification portion of the surface-modified metal nanoparticles and suppress a loss of the surface modification portion, in other words, they have excellent dispersion stability, and that they rapidly evaporate even in low-temperature sintering, and thus can improve sintering properties of the metal nanoparticles, i.e., can impart low-temperature sintering properties.
The alcohol (b-1) includes an aliphatic alcohol, an alicyclic alcohol, and an aromatic alcohol, and, among them, an alicyclic alcohol (i.e., an alcohol having an alicyclic structure) is preferred in terms of providing excellent dispersibility of the surface-modified metal nanoparticles.
Thus, the alcohol (b-1) is preferably an alicyclic secondary alcohol and/or an alicyclic tertiary alcohol.
The alicyclic alcohols include monocyclic alcohols and polycyclic alcohols, but, particularly, a monocyclic alcohol is preferred in terms of providing particularly excellent dispersibility of the surface-modified metal nanoparticles, and having low viscosity and excellent applicability.
A boiling point of the alcohol (b-1) is, for example, preferably 130°C or higher, and more preferably 170°C or higher. Especially, for example, when the surface-modified metal nanoparticles are contained in a high concentration (e.g., when a content (in terms of metal element) thereof is 45 wt.% or greater of a total amount of the conductive ink), the boiling point of the alcohol (b-1) is preferably 185°C or higher, and even more preferably 190°C or higher. The upper limit of the boiling point is, for example, 300°C, preferably 250°C, and particularly preferably 220°C. When the boiling point is 130°C or higher, volatilization at a temperature during printing can be suppressed, and excellent applicability can be obtained. In addition, when the boiling point is 300°C or lower, the alcohol (b-1) rapidly volatilizes even in low-temperature sintering, providing a sintered body with excellent electrical conductivity. In other words, excellent low-temperature sintering properties are obtained. On the other hand, when the boiling point falls below the range described above, fluidity of the conductive ink decreases during application, which may make it difficult to form a uniform coating film.
The monocyclic secondary alcohol is, for example, cyclohexanol, and is preferably a cyclohexanol that may have a substituent, such as 2-ethylcyclohexanol, 1-cyclohexylethanol, 3,5-dimethylcyclohexanol, 3,3,5-trimethylcyclohexanol, 2,3,5-trimethylcyclohexanol, 3,4,5-trimethylcyclohexanol, 2,3,4-trimethylcyclohexanol, 4-(tert-butyl)-cyclohexanol, 3,3,5,5-tetramethylcyclohexanol, or 2-isopropyl-5-methyl-cyclohexanol (i.e., menthol), or the corresponding cycloheptanol, and particularly preferably a cyclohexanol or cycloheptanol having an alkyl group having from 1 to 3 carbon atoms. Especially, a cyclohexanol having an alkyl group having from 1 to 3 carbon atoms is preferred.
The monocyclic tertiary alcohol is preferably a tertiary alcohol having a 6- to 7-membered ring (in particular, a cyclohexane ring) structure, such as 1-methylcyclohexanol, 4-isopropyl-1-methylcyclohexanol, 2-cyclohexyl-2-propanol, or 2-(4-methylcyclohexyl)-2-propanol.
Especially, the alcohol (b-1) preferably contains at least a secondary alcohol (in particular, a monocyclic secondary alcohol) in terms of providing excellent initial dispersibility of the surface-modified metal nanoparticles (A) and being able to stably maintain excellent dispersibility for a long period of time. A content of the secondary alcohol is, for example, preferably 60 wt.% or greater, more preferably 70 wt.% or greater, particularly preferably 80 wt.% or greater, and most preferably 90 wt.% or greater of a total amount of the alcohol (b-1). Note that the upper limit is 100 wt.%.

Hydrocarbon (b-2)

The hydrocarbon (b-2) includes an aliphatic hydrocarbon, an alicyclic hydrocarbon, and an aromatic hydrocarbon. In an embodiment of the present disclosure, among them, an aliphatic hydrocarbon and/or an alicyclic hydrocarbon are/is preferred in terms of providing particularly excellent dispersibility of the surface-modified metal nanoparticles.

A boiling point of the hydrocarbon (b-2) is, for example, preferably 130°C or higher, more preferably 170°C or higher, and even more preferably 190°C or higher for the same reason as for the alcohol (b-1). Especially, for example, when the surface-modified metal nanoparticles are contained in a high concentration (e.g., when a content (in terms of metal element) thereof is 45 wt.% or greater based on the total amount of the conductive ink), the boiling point of the hydrocarbon (b-2) is preferably 200°C or higher, more preferably 230°C or higher, particularly preferably 250°C or higher, and most preferably 270°C or higher. In addition, the upper limit of the boiling point is, for example, 300°C.

The aliphatic hydrocarbon is, for example, preferably a chain aliphatic hydrocarbon having 10 or more (e.g. from 10 to 20) carbon atoms, such as n-decane, n-dodecane, n-tridecane, n-tetradecane, n-pentadecane, n-hexadecane, n-heptadecane, n-octadecane, or n-nonadecane. Among them, a chain aliphatic hydrocarbon having 12 or more (e.g., from 12 to 20 and preferably from 12 to 18) carbon atoms, and, especially, 14 or more (e.g., from 14 to 20 and preferably from 14 to 18) carbon atoms is preferred.

Examples of the alicyclic hydrocarbon include monocyclic compounds, such as cyclohexanes, cyclohexenes, terpene-based 6-membered ring compounds, cycloheptane, cycloheptene, cyclooctane, cyclooctene, cyclodecane, and cyclododecene; and polycyclic compounds, such as bicyclo[2.2.2]octane and decalin.

Examples of the cyclohexanes include compounds with a 6-membered ring having an alkyl group having 2 or more (e.g., from 2 to 5) carbon atoms, such as ethylcyclohexane, n-propylcyclohexane, isopropylcyclohexane, n-butylcyclohexane, isobutylcyclohexane, sec-butylcyclohexane, and tert-butylcyclohexane; and bicyclohexyl.

Examples of the terpene-based 6-membered ring compounds include α-pinene, β-pinene, limonene, α-terpinene, β-terpinene, γ-terpinene, and terpinolene.

Especially, the hydrocarbon (b-2) preferably contains at least an aliphatic hydrocarbon (particularly preferably a chain aliphatic hydrocarbon, and most preferably a chain aliphatic hydrocarbon having 15 or more carbon atoms). A content of the aliphatic hydrocarbon is, for example, preferably 60 wt.% or greater, more preferably 70 wt.% or greater, particularly preferably 80 wt.% or greater, and most preferably 90 wt.% or greater of a total amount of the hydrocarbon (b-2). Note that the upper limit is 100 wt.%.

Also, the dispersion medium includes a terpene solvent (b-3) and a glycol solvent (b-4).

The terpene solvent (b-3) includes those having a boiling point of 130°C of higher (for example, from 130 to 300°C, and preferably from 200 to 300°C).

Furthermore, the use of a terpene solvent having a viscosity (at 20°C) of, for example, from 50 to 250 mPa•s (particularly preferably from 100 to 250 mPa•s, and most preferably from 150 to 250 mPa•s) as the terpene solvent (b-3) is preferred in that the viscosity of the obtained conductive ink can be appropriately adjusted, and that thin lines can be drawn with excellent accuracy. Note that the viscosity of the solvent is a value at 20°C and a shear rate of 20 (1/s) measured using a rheometer (trade name "Physica MCR301 ", available from Anton Paar).

Examples of the terpene solvent (b-3) include 4-(1'-acetoxy-1'-methylester)-cyclohexanol acetate, 1,2,5,6-tetrahydrobenzyl alcohol, 1,2,5,6-tetrahydrobenzyl acetate, cyclohexyl acetate, 2-methylcyclohexyl acetate; 4-t-butylcyclohexyl acetate, terpineol, dihydroterpineol, dihydroterpinyl acetate, α-terpineol, β-terpineol, γ-terpineol, L-α-terpineol, dihydroterpinyloxyethanol, tarpinyl methyl ether, and dihydroterpinyl methyl ether. One of these can be used alone or two or more in combination. In the present invention, for example, the trade names "Terusolve MTPH", "Terusolve IPG", "Terusolve IPG-Ac", "Terusolve IPG-2Ac", "Terpineol C" (mixtures of α-terpineol, β-terpineol, and γ-terpineol, boiling point: 218°C; viscosity: 54 mPa•s), "Terusolve DTO-210", "Terusolve THA-90", "Terusolve THA-70" (boiling point: 223°C, viscosity: 198 mPa•s), "Terusolve TOE-100" (all available from Nippon Terpene Chemicals, Inc.), and the like can be used.

The glycol solvent (b-4) in an embodiment of the present disclosure is not particularly limited, and examples thereof include glycol ether solvents having a boiling point of 130°C or higher.

Examples of the glycol ether solvent may include compounds represented by Formula (b) below:

$$R^{11}\text{-}(O\text{-}R^{13})_m\text{-}OR^{12} \qquad (b)$$

where in Formula (b), $R^{11}$ and $R^{12}$ are the same or different and represent alkyl or acyl groups, $R^{13}$ represents an alkylene group having from 1 to 6 carbon atoms, and m represents an integer of 1 or greater.

Examples of the alkyl groups in $R^{11}$ and $R^{12}$ described above may include linear or branched alkyl groups having from 1 to 10 carbon atoms (preferably, from 1 to 5).

Examples of the acyl groups (RCO-groups) in $R^{11}$ and $R^{12}$ described above may include acyl groups (for example, acetyl groups, propionyl groups, butyryl groups, isobutyryl groups, and pivaloyl groups) in which R described above is a linear or branched alkyl group having from 1 to 10 carbon atoms (preferably, from 1 to 5).

In an embodiment of the present disclosure, among these, a compound in which $R^{11}$ and $R^{12}$ in Formula (b) are groups different from each other (different alkyl groups, different acyl groups, or an alkyl group and an acyl group) is preferred, and a compound in which $R^{11}$ and $R^{12}$ in Formula (b) are alkyl groups different from each other is particularly preferred. A compound including a linear or branched alkyl group having from 4 to 10 carbon atoms (preferably from 4 to 6) and a linear or branched alkyl group having from 1 to 3 carbon atoms is most preferred.

Examples of such an alkylene group in $R^{13}$ described above include a methylene group, a methylmethylene group, a dimethylmethylene group, an ethylene group, a propylene group, a trimethylene group, a tetramethylene group, a pentamethylene group, and a hexamethylene group. In an embodiment of the present disclosure, among these, an alkylene group having from 1 to 4 carbon atoms is preferred, and an alkylene group having from 1 to 3 carbon atoms is particularly preferred. An alkylene group having from 2 to 3 carbon atoms is most preferred.

m is an integer of 1 or greater and, for example, an integer of from 1 to 8, preferably an integer of from 1 to 3, and particularly preferably an integer of from 2 to 3.

The boiling point of the compound represented by Formula (b) is, for example, 130°C or higher (for example, from 130 to 300°C), preferably 170°C or higher, and particularly preferably 200°C or higher.

Examples of the compound represented by Formula (b) include glycol diether, glycol ether acetate, and glycol diacetate such as ethylene glycol methyl ether acetate (boiling point: 145°C), ethylene glycol-n-butyl ether acetate (boiling point: 188°C), propylene glycol methyl-n-propyl ether (boiling point: 131°C); propylene glycol methyl-n-butyl ether (boiling point: 155°C), propylene glycol methyl isoamyl ether (boiling point: 176°C), propylene glycol diacetate (boiling point: 190°C), propylene glycol methyl ether acetate (boiling point: 146°C), 3-methoxybutyl acetate (boiling point: 171°C), 1,3-butylene glycol diacetate (boiling point: 232°C), 1,4-butanediol diacetate (boiling point: 232°C), 1,6-hexanediol diacetate (boiling point: 260°C), diethylene glycol dimethyl ether (boiling point: 162°C), diethylene glycol diethyl ether (boiling point: 189°C), diethylene glycol dibutyl ether (boiling point: 256°C), diethylene glycol ethyl methyl ether (boiling point: 176°C), diethylene glycol isopropyl methyl ether (boiling point: 179°C), diethylene glycol methyl-n-butyl ether (boiling point: 212°C), diethylene glycol-n-butyl ether acetate (boiling point: 247°C), diethylene glycol ethyl ether acetate (boiling point: 218°C), diethylene glycol butyl ether acetate (boiling point: 246.8°C), dipropylene glycol methyl-isopentyl ether (boiling point: 227°C), dipropylene glycol dimethyl ether (boiling point: 175°C), dipropylene glycol methyl-n-propyl ether (boiling point: 203°C), dipropylene glycol methyl-n-butyl ether (boiling point: 216°C), dipropylene glycol methyl cyclopentyl ether (boiling point: 286°C), dipropylene glycol methyl ether acetate (boiling point: 195°C), triethylene glycol dimethyl ether (boiling point: 216°C), triethylene glycol methyl-n-butyl ether (boiling point: 261°C), tripropylene glycol methyl-n-propyl ether (boiling point: 258°C), tripropylene glycol dimethyl ether (boiling point: 215°C), and tetraethylene glycol dimethyl ether (boiling point: 275°C). One of these can be used alone or two or more in combination.

Examples of the glycol ether solvent may include compounds (glycol monoethers) represented by Formula (b') below:

$$R^{14}\text{-}(O\text{-}R^{15})_n\text{-}OH \qquad (b')$$

where in Formula (b'), $R^{14}$ represents an alkyl group or an aryl group, $R^{15}$ represents an alkylene group having from 1 to 6 carbon atoms, and n is an integer of 1 or greater.

Examples of the alkyl group in $R^{14}$ described above may include linear or branched alkyl groups having from 1 to 10 carbon atoms (preferably, from 1 to 5). Examples of the aryl group may include aryl groups having from 6 to 10 carbon atoms (for example, phenyl groups).

Examples of the alkylene group in $R^{15}$ described above include linear or branched alkylene groups such as a methylene group, a methylmethylene group, a dimethylmethylene group, an ethylene group, a propylene group, a trimethylene group, a tetramethylene group, a pentamethylene group, and a hexamethylene group. In an embodiment of the present invention, among these, an alkylene group having from 1 to 4 carbon atoms is preferred, and an alkylene group having from 1 to 3 carbon atoms is particularly preferred. An alkylene group having from 2 to 3 carbon atoms is most preferred.

n is an integer of 1 or greater and, for example, an integer of from 1 to 8, preferably an integer of from 1 to 3, and particularly preferably an integer of from 2 to 3.

The boiling point of the compound represented by Formula (b') is, for example, 130°C or higher (for example, from 130 to 310°C), preferably from 130 to 250°C, particularly preferably from 130 to 200°C, most preferably from 130 to 180°C, and especially preferably from 140 to 180°C.

Examples of the compound represented by Formula (b') include ethylene glycol monomethyl ether (boiling point: 124°C), ethylene glycol monoisopropyl ether (boiling point: 141.8°C), ethylene glycol monobutyl ether (boiling point: 171.2°C), ethylene glycol monoisobutyl ether (boiling point: 160.5°C), ethylene glycol monotert-butyl ether (boiling point: 152°C), ethylene glycol monohexyl ether (boiling point: 208°C), ethylene glycol mono-2-ethyl hexyl ether (boiling point: 229°C), ethylene glycol monophenyl ether (boiling point: 244.7°C), ethylene glycol monobenzyl ether (boiling point: 256°C), diethylene glycol monomethyl ether (boiling point: 194°C), diethylene glycol monobutyl ether (=butyl carbitol, boiling point: 230°C), diethylene glycol monoisobutyl ether (boiling point: 220°C), diethylene glycol monoisopropyl ether (boiling point: 207°C), diethylene glycol monopentyl ether (boiling point: 162°C), diethylene glycol monoisopentyl ether, diethylene glycol monohexyl ether (=hexyl carbitol, boiling point: 259.1°C), diethylene glycol mono-2-ethyl hexyl ether (boiling point: 272°C), diethylene glycol monophenyl ether (boiling point: 283°C), diethylene glycol monobenzyl ether (boiling point: 302°C), triethylene glycol monomethyl ether (boiling point: 249°C), triethylene glycol monobutyl ether

(boiling point: 271.2°C), propylene glycol monoethyl ether (boiling point: 132.8°C), propylene glycol monopropyl ether (boiling point: 149°C), propylene glycol monobutyl ether (boiling point: 170°C), dipropylene glycol monomethyl ether (boiling point: 188°C), and 3-methoxy-1-butanol (boiling point: 158°C). One of these can be used alone or two or more in combination.

The conductive ink according to an embodiment of the present disclosure may contain, as a dispersion medium having a boiling point of 130°C or higher, one or more types of other solvents [e.g., ethyl lactate acetate (boiling point: 181°C), tetrahydrofurfuryl acetate (boiling point: 195°C), tetrahydrofurfuryl alcohol (boiling point: 176°C), ethylene glycol (boiling point: 197°C), and the like], in addition to the alcohol (b-1), the hydrocarbon (b-2), the terpene solvent (b-3), the compound represented by Formula (b) above and the compound represented by Formula (b') above. However, the content of such additional solvents having a boiling point of 130°C or higher is 30 wt.% or less, preferably 20 wt.% or less, particularly preferably 15 wt.% or less, most preferably 10 wt.% or less, even more preferably 5 wt.% or less, and especially preferably 1 wt.% or less of a total amount of the dispersion medium contained in the conductive ink according to an embodiment of the present invention.

Binder resin

In order to adjust the viscosity of the conductive ink according to an embodiment of the present disclosure to an appropriate viscosity, a binder resin can be further contained as a second ink resin in addition to the first ink resin. Examples of the binder resin include vinyl chloride-vinyl acetate copolymer resins, polyester resins, acrylic resins, and cellulosic resins. One of these can be used alone or two or more in combination. In an embodiment of the present disclosure, among them, a cellulosic resin which less affects the electrical conductivity is preferably used, and commercially available products such as the trade names "ETHOCEL std.200" and "ETHOCEL std.300" (both available from The Dow Chemical Company) can be used.

A content of the binder resin (for example, cellulosic resin) when contained in the conductive ink according to an embodiment of the present disclosure is not particularly limited, and is, for example, approximately from 0.1 to 5.0 wt.%, and preferably from 0.5 to 3.0 wt.% of the total amount of the conductive ink.

Method for manufacturing conductive ink

When the conductive ink according to an embodiment of the present disclosure contains surface-modified metal nanoparticles, the surface-modified metal nanoparticles can be manufactured, for example, through a step of mixing a metal compound and an organic protective agent and forming a complex containing the metal compound and the organic protective agent (complex formation), a step of thermally decomposing the complex (thermal decomposition), and, as necessary, a step of washing the reaction product (washing), and the conductive ink can be manufactured through a step of mixing the obtained surface-modified metal nanoparticles with a first ink resin and, as necessary, a dispersion medium, a binder resin (second ink resin), and any other additive (conductive ink preparation).

Formation of complex

The formation of the complex is a step of mixing a metal compound and an organic protective agent and forming a complex containing the metal compound and the organic protective agent. In an embodiment of the present disclosure, a silver compound is preferably used as the metal compound, because the nano-sized silver particles are fused to each other at a temperature of approximately 100°C, and thus a wire having excellent electrical conductivity can be formed even on a general-purpose plastic substrate with low heat resistance. Particularly, a silver compound that is readily decomposed upon heating and produces metallic silver is preferably used. Examples of such a silver compound include silver carboxylates, such as silver formate, silver acetate, silver oxalate, silver malonate, silver benzoate, and silver phthalate; silver halides, such as silver fluoride, silver chloride, silver bromide, and silver iodide; and silver sulfate, silver nitrate, and silver carbonate. In an embodiment of the present disclosure, among them, silver oxalate is preferred in that it has a high silver content, can be thermally decomposed without using a reducing agent, and thus an impurity derived from the reducing agent is less likely to be mixed into the conductive ink.

As the organic protective agent, a compound having at least one type of functional group selected from the group consisting of a carboxyl group, a hydroxyl group, an amino group, a sulfo group, and a thiol group, in that the coordination of non-covalent electron pairs in the heteroatom to the metal nanoparticles can exert an effect of strongly suppressing agglomeration between the metal nanoparticles. A compound having from 4 to 18 carbon atoms and having at least one type of functional group selected from the group consisting of a carboxyl group, a hydroxyl group, an amino group, a sulfo group, and a thiol group is particularly preferred.

The organic protective agent is preferably a compound having an amino group, and most preferably a compound having from 4 to 18 carbon atoms and having an amino group, that is, an amine having from 4 to 18 carbon atoms.

The amine is a compound in which at least one hydrogen atom of ammonia is substituted with a hydrocarbon group, and includes a primary amine, a secondary amine, and a tertiary amine. In addition, the amine may be a monoamine or a polyamine, such as a diamine. One of these can be used alone or two or more in combination.

The amine preferably contains at least one selected from a monoamine (1) having 6 or more carbon atoms in total and represented by Formula (a-1) below, where $R^1$, $R^2$, and $R^3$ are the same or different and are hydrogen atoms or monovalent hydrocarbon groups (with the proviso that the case in which $R^1$, $R^2$, and $R^3$ are all hydrogen atoms is omitted); monoamine (2) having 5 or less carbon atoms in total and represented by Formula (a-1) below, where $R^1$, $R^2$, and $R^3$ are the same or different and are hydrogen atoms or monovalent hydrocarbon groups (with the proviso that the case in which $R^1$, $R^2$, and $R^3$ are all hydrogen atoms is omitted); and a diamine (3) having 8 or less carbon atoms in total and represented by Formula (a-2), where $R^4$ to $R^7$ are the same or different and are hydrogen atoms or monovalent hydrocarbon groups, and $R^8$ is a divalent hydrocarbon group; and in particular, preferably contains the monoamine (1) in combination with the monoamine (2) and/or the diamine (3).

[Chem. 1]

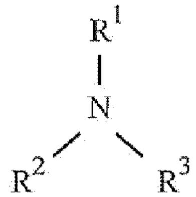

(a-1)

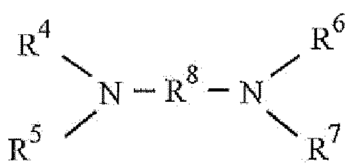

(a-2)

The hydrocarbon group includes an aliphatic hydrocarbon group, an alicyclic hydrocarbon group, and an aromatic hydrocarbon group, and among them, an aliphatic hydrocarbon group or an alicyclic hydrocarbon group is preferred, and in particular, an aliphatic hydrocarbon group is preferred. Thus, the monoamine (1), the monoamine (2), and the diamine (3) are preferably an aliphatic monoamine (1), an aliphatic monoamine (2), and an aliphatic diamine (3).

In addition, the monovalent aliphatic hydrocarbon group includes an alkyl group and an alkenyl group. The monovalent alicyclic hydrocarbon group includes a cycloalkyl group and a cycloalkenyl group. Furthermore, the divalent aliphatic hydrocarbon group includes an alkylene group and an alkenylene group, and the divalent alicyclic hydrocarbon group includes a cycloalkylene group and a cycloalkenylene group.

Examples of the monovalent hydrocarbon group in $R^1$, $R^2$, and $R^3$ may include alkyl groups having approximately from 1 to 18 carbon atoms, such as a methyl group, an ethyl group, a propyl group, an isopropyl group, a butyl group, an isobutyl group, an sec-butyl group, a tert-butyl group, a pentyl group, a hexyl group, a decyl group, a dodecyl group, a tetradecyl group, an octadecyl group; alkenyl groups having approximately from 2 to 18 carbon atoms, such as a vinyl group, an allyl group, a methallyl group, a 1-propenyl group, an isopropenyl group, a 1-butenyl group, a 2-butenyl group, a 3-butenyl group, a 1-pentenyl group, a 2-pentenyl group, a 3-pentenyl group, a 4-pentenyl group, and a 5-hexenyl

group; cycloalkyl groups having approximately from 3 to 18 carbon atoms, such as a cyclopropyl group, a cyclobutyl group, a cyclopentyl group, a cyclohexyl group, and a cyclooctyl group; and cycloalkenyl groups having approximately from 3 to 18 carbon atoms, such as a cyclopentenyl group and a cyclohexenyl group.

Examples of the monovalent hydrocarbon groups in $R^4$ to $R^7$ may include, among those exemplified above, alkyl groups having approximately from 1 to 7 carbon atoms, alkenyl groups having approximately from 2 to 7 carbon atoms, cycloalkyl groups having approximately from 3 to 7 carbon atoms, and cycloalkenyl groups having approximately from 3 to 7 carbon atoms.

Examples of the divalent hydrocarbon group in $R^8$ may include alkylene groups having from 1 to 8 carbon atoms, such as a methylene group, a methylmethylene group, a dimethylmethylene group, an ethylene group, a propylene group, a trimethylene group, a tetramethylene group, a pentamethylene group, and a heptamethylene group; and alkenylene groups having from 2 to 8 carbon atoms, such as a vinylene group, a propenylene group, a 1-butenylene group, a 2-butenylene group, a butadienylene group, a pentenylene group, a hexenylene group, a heptenylene group, and an octenylene group.

The hydrocarbon groups in the above $R^1$ to $R^8$ may have a substituent of various types [e.g., such as a halogen atom, an oxo group, a hydroxyl group, a substituted oxy group (e.g., such as a $C_{1-4}$ alkoxy group, a $C_{6-10}$ aryloxy group, a $C_{7-16}$ aralkyloxy group, or a $C_{1-4}$ acyloxy group), a carboxyl group, a substituted oxycarbonyl group (e.g., such as a $C_{1-4}$ alkoxycarbonyl group, a $C_{6-10}$ aryloxycarbonyl group, or a $C_{7-16}$ aralkyloxycarbonyl group), a cyano group, a nitro group, a sulfo group, or a heterocyclic group]. In addition, the hydroxyl group and the carboxyl group may be protected with a protecting group commonly used in the field of organic synthesis.

The monoamine (1) is a compound that is adsorbed on the surfaces of the metal nanoparticles and prevents agglomeration of the metal nanoparticles and enlargement of the agglomeration, that is, a compound having a function of imparting high dispersibility to the metal nanoparticles. Examples of the monoamine (1) include primary monoamines having a linear alkyl group, such as n-hexylamine, n-heptylamine, n-octylamine, n-nonylamine, n-decylamine, n-undecylamine, and n-dodecylamine; primary amines having a branched alkyl group, such as isohexylamine, 2-ethylhexylamine, and tert-octylamine; a primary amine having a cycloalkyl group, such as cyclohexylamine; a primary amine having an alkenyl group, such as oleylamine; secondary amines having a linear alkyl group, such as N,N-dipropylamine, N,N-dibutylamine, N,N-dipentylamine, N,N-dihexylamine, N,N-dipeptylamine, N,N-dioctylamine, N,N-dinonylamine, N,N-didecylamine, N,N-diundecylamine, N,N-didodecylamine, and N-propyl-N-butylamine; secondary amines having a branched alkyl group, such as N,N-diisohexylamine and N,N-di(2-ethylhexyl)amine; tertiary amines having a linear alkyl group, such as tributylamine and trihexylamine; and tertiary amines having a branched alkyl group, such as triisohexylamine and tri(2-ethylhexyl)amine.

Among the above monoamines (1), an amine (in particular, a primary amine) having a linear alkyl group having from 6 to 18 carbon atoms in total (more preferably up to 16 and particularly preferably up to 12 carbon atoms in total) is preferred in that such an amine can provide space between the metal nanoparticles when the amino groups is adsorbed on the metal nanoparticle surfaces, thus providing the effect of preventing agglomeration of the metal nanoparticles, and such an amine can be easily removed during sintering. In particular, n-hexylamine, n-heptylamine, n-octylamine, n-nonylamine, n-decylamine, n-undecylamine, n-dodedeyclamine, and the like are preferred.

The monoamine (2) has a shorter hydrocarbon chain than that of the monoamine (1), and thus the function of the monoamine (2) itself to impart high dispersibility to the metal nanoparticles is low. However, the monoamine (2) has a high coordination ability to a metal atom due to its higher polarity than that of the monoamine (1), and thus has an effect of promoting complex formation. In addition, the monoamine (2) has a short hydrocarbon chain and thus can be removed from the metal nanoparticle surfaces in a short time (e.g., not longer than 30 minutes and preferably not longer than 20 minutes) even in low-temperature sintering, thus providing a sintered body with excellent electrical conductivity.

Examples of the monoamine (2) include a primary amine having a linear or branched alkyl group and having from 2 to 5 carbon atoms in total (preferably from 4 to 5 carbon atoms in total), such as n-butylamine, isobutylamine, sec-butylamine, tert-butylamine, pentylamine, isopentylamine, and tert-pentylamine; and a secondary amine having a linear or branched alkyl group and having from 2 to 5 carbon atoms in total (preferably from 4 to 5 carbon atoms in total), such as N,N-diethylamine. In an embodiment of the present disclosure, among these, a primary amine having a linear alkyl group and having from 2 to 5 carbon atoms in total (preferably from 4 to 5 carbon atoms in total) is preferred.

The diamine (3) has 8 or less carbon atoms in total and has a high coordination ability to a metal atom due to its higher polarity than that of the monoamine (1), and thus has an effect of promoting complex formation. In addition, the diamine (3) has an effect of promoting thermal decomposition of the complex at lower temperature and in a short time in the thermal decomposition of the complex, and the use of the diamine (3) can perform the production of the surface-modified metal nanoparticles more efficiently. Furthermore, the surface-modified metal nanoparticles having a configuration of being coated with the protective agent containing the diamine (3) exhibit excellent dispersion stability in a highly polar dispersion medium. Moreover, the diamine (3) has a short hydrocarbon chain and thus can be removed from the metal nanoparticle surfaces in a short time (e.g., not longer than 30 minutes and preferably not longer than 20 minutes) even by low-temperature sintering, thus providing a sintered body with excellent electrical conductivity.

Examples of the diamine (3) may include diamines in which $R^4$ to $R^7$ in Formula (a-2) are hydrogen atoms, and $R^8$ is a linear or branched alkylene group, such as 2,2-dimethyl-1,3-propanediamine, 1,4-butanediamine, 1,5-pentanediamine, 1,6-hexanediamine, 1,7-heptanediamine, 1,8-octanediamine, and 1,5-diamino-2-methylpentane; diamines in which $R^4$ and $R^6$ in Formula (a-2) are the same or different and linear or branched alkyl groups, $R^5$ and $R^7$ are hydrogen atoms, and $R^8$ is a linear or branched alkylene group, such as N,N'-dimethylethylenediamine, N,N'-diethylethylenediamine, N,N'-dimethyl-1,3-propanediamine, N,N'-diethyl-1,3-propanediamine, N,N'-dimethyl-1,4-butanediamine, N,N'-diethyl-1,4-butanediamine, and N,N'-dimethyl-1,6-hexanediamine; and diamines in which $R^4$ and $R^5$ in Formula (a-2) are the same or different and linear or branched alkyl groups, $R^6$ and $R^7$ are hydrogen atoms, and $R^8$ is a linear or branched alkylene group, such as N,N-dimethylethylenediamine, N,N-diethylethylenediamine, N,N-dimethyl-1,3-propanediamine, N,N-diethyl-1,3-propanediamine, N,N-dimethyl-1,4-butanediamine, N,N-diethyl-1,4-butanediamine, and N,N-dimethyl-1,6-hexanediamine.

Among them, diamines in which $R^4$ and $R^5$ in Formula (a-2) above are the same or different and linear or branched alkyl groups, $R^6$ and $R^7$ are hydrogen atoms, and $R^8$ is a linear or branched alkylene group [in particular, diamines in which $R^4$ and $R^5$ in Formula (a-2) are linear alkyl groups, $R^6$ and $R^7$ are hydrogen atoms, and $R^8$ is a linear alkylene group] are preferred.

In diamines in which $R^4$ and $R^5$ in Formula (a-2) are the same or different and are linear or branched alkyl groups, and $R^6$ and $R^7$ are hydrogen atoms, that is, diamines having a primary amino group and a tertiary amino group, the primary amino group has a high coordination ability to a metal atom, but the tertiary amino group has a poor coordination ability to a metal atom, and thus this prevents a resulting complex from becoming excessively complicated, thereby allowing the complex to be thermally decomposed at lower temperature and in a shorter time in the thermal decomposition of the complex. Among them, diamines having 6 or less (e.g., from 1 to 6, preferably from 4 to 6) carbon atoms in total are preferred, and diamines having 5 or less (e.g., from 1 to 5, preferably from 4 to 5) carbon atoms in total are more preferred in that they can be removed from the metal nanoparticle surfaces in a short time in low-temperature sintering.

The proportion of the content of the monoamine (1) in a total amount of the organic protective agent contained in the conductive ink according to an embodiment of the present disclosure, and the proportion of a total content of the monoamine (2) and the diamine (3) therein are preferably within the ranges described below.

Content of monoamine (1): for example, from 5 to 65 mol% (the lower limit is preferably 10 mol%, particularly preferably 20 mol%, and most preferably 30 mol%. In addition, the upper limit is preferably 60 mol%, and particularly preferably 50 mol%)

Total content of monoamine (2) and diamine (3): for example, from 35 to 95 mol% (the lower limit is preferably 40 mol%, and particularly preferably 50 mol%. In addition, the upper limit is preferably 90 mol%, particularly preferably 80 mol%, and most preferably 70 mol%)

The proportion of the content of the monoamine (2) in the total amount of the organic protective agent contained in the conductive ink according to an embodiment of the present disclosure, and the proportion of the content of the diamine (3) therein are preferably within the ranges described below.

Content of monoamine (2): for example, from 5 to 65 mol% (the lower limit is preferably 10 mol%, particularly preferably 20 mol%, and most preferably 30 mol%. In addition, the upper limit is preferably 60 mol%, and particularly preferably 50 mol%)

Content of diamine (3): for example, from 5 to 50 mol% (the lower limit is preferably 10 mol%. In addition, the upper limit is preferably 40 mol%, and particularly preferably 30 mol%)

The monoamine (1) contained in the above range provides dispersion stability of the metal nanoparticles. With the content of the monoamine (1) below the above range, the metal nanoparticles would tend to be prone to agglomeration. On the other hand, the content of the monoamine (1) exceeding the above range would cause difficulty in removing the organic protective agent from the metal nanoparticle surfaces in a short time when the sintering temperature is low, tending to reduce the electrical conductivity of the resulting sintered body.

The monoamine (2) contained in the above range provides the effect of promoting complex formation. In addition, this allows the organic protective agent to be removed from the metal nanoparticle surfaces in a short time even when the sintering temperature is low, providing a sintered body with excellent electrical conductivity.

The diamine (3) contained in the above range easily provides the effect of promoting complex formation and the effect of promoting the thermal decomposition of the complex. In addition, the surface-modified metal nanoparticles having a configuration of being coated with the protective agent containing the diamine (3) exhibit excellent dispersion stability in a highly polar dispersion medium.

In an embodiment of the present disclosure, the use of the monoamine (2) and/or the diamine (3) having a high coordination ability to metal atoms of the metal compound is preferred, in that the use can reduce the amount of the monoamine (1) used depending on the proportion of the monoamine (2) and/or the diamine (3) used and can remove the organic protective agent from the metal nanoparticle surfaces in a short time even when the sintering temperature is low, providing a sintered body with excellent electrical conductivity.

In an embodiment of the present disclosure, The amine used as the organic protective agent in an embodiment of the present disclosure may contain an additional amine other than the monoamine (1), the monoamine (2), and the diamine (3), but the proportion of the total content of the monoamine (1), the monoamine (2), and the diamine (3) accounting for the total amines contained in the protective agent is, for example, preferably from 60 wt.% or greater, particularly preferably 80 wt.% or greater, and most preferably 90 wt.% or greater. Note that the upper limit is 100 wt.%. That is, the content of the additional amine is preferably not greater than 40 wt.%, particularly preferably not greater than 20 wt.%, and most preferably not greater than 10 wt.%.

The amount of the organic protective agent [in particular, monoamine (1) + monoamine (2) + diamine (3)] used is not particularly limited but is preferably approximately from 1 to 50 mol, particularly preferably from 2 to 50 mol, and most preferably from 6 to 50 mol, relative to 1 mol of metal atoms in the metal compound of the raw material. When the amount of the organic protective agent is below the above range, the metal compound not converted to a complex would be prone to remain in the formation of the complex, tending to be difficult to impart sufficient dispersibility to the metal nanoparticles.

In an embodiment of the present disclosure, for the purpose of further improving the dispersibility of the metal nanoparticles, one or more types of compounds having a carboxyl group (for example, compounds having from 4 to 18 carbon atoms and having a carboxyl group, preferably aliphatic monocarboxylic acids having from 4 to 18 carbon atoms) may be contained together with the compound having an amino group as the organic protective agent.

Examples of the aliphatic monocarboxylic acid may include saturated aliphatic monocarboxylic acids having 4 or more carbon atoms, such as butanoic acid, pentanoic acid, hexanoic acid, heptanoic acid, octanoic acid, nonanoic acid, decanoic acid, undecanoic acid, dodecanoic acid, tridecanoic acid, tetradecanoic acid, pentadecanoic acid, hexadecanoic acid, heptadecanoic acid, octadecanoic acid, nonadecanoic acid, and icosanoic acid; and unsaturated aliphatic monocarboxylic acids having 8 or more carbon atoms, such as oleic acid, elaidic acid, linoleic acid, palmitoleic acid, and eicosenoic acid.

Among them, saturated or unsaturated aliphatic monocarboxylic acids having from 8 to 18 carbon atoms (in particular, octanoic acid and oleic acid) are preferred. When the carboxyl groups of the aliphatic monocarboxylic acid is adsorbed on the metal nanoparticle surfaces, the saturated or unsaturated aliphatic hydrocarbon chain having from 8 to 18 carbon atoms causes a steric hindrance and thus can provide space between the metal nanoparticles, thus improving the effect of preventing agglomeration of the metal nanoparticles.

The amount of the compound having a carboxyl group used is, for example, approximately from 0.05 to 10 mol, preferably from 0.1 to 5 mol, and particularly preferably from 0.5 to 2 mol, relative to 1 mol of metal atoms in the metal compound. The amount of the compound having a carboxyl group used below the above range would cause difficulty in providing an effect of improving dispersion stability. On the other hand, the compound having a carboxyl group, even when used in an excessive amount, would saturate the effect of improving the dispersion stability while it tends to be difficult to remove the compound by low-temperature sintering.

The reaction between the organic protective agent and the metal compound is performed in the presence or absence of the reaction solvent. As the reaction solvent, for example, an alcohol having 3 or more carbon atoms can be used.

Examples of the alcohol having 3 or more carbon atoms include n-propanol (boiling point: 97°C), isopropanol (boiling point: 82°C), n-butanol (boiling point: 117°C), isobutanol (boiling point: 107.89°C), sec-butanol (boiling point: 99.5°C), tert-butanol (boiling point: 82.45°C), n-pentanol (boiling point: 136°C), n-hexanol (boiling point: 156°C), n-octanol (boiling point: 194°C), and 2-octanol (boiling point: 174°C). Among them, alcohols having from 4 to 6 carbon atoms are preferred, and in particular, n-butanol and n-hexanol are preferred in that higher temperature can be set for the thermal decomposition of the complex to be performed later and in terms of the convenience of the post-treatment of the resulting surface-modified metal nanoparticles.

In addition, the amount of the reaction solvent used is, for example, 120 parts by weight or greater, preferably 130 parts by weight or greater, and more preferably 150 parts by weight or greater, relative to 100 parts by weight of the metal compound. The upper limit of the amount of the reaction solvent used is, for example, 1000 parts by weight, preferably 800 parts by weight, and particularly preferably 500 parts by weight.

The reaction between the organic protective agent and the metal compound is preferably performed at ordinary temperature (from 5 to 40°C). The reaction is accompanied by heat generation due to the coordination reaction of the organic protective agent to the metal compound and thus may be performed while the reaction mixture is appropriately cooled to the above temperature range.

The reaction time between the organic protective agent and the metal compound is, for example, approximately from 30 minutes to 3 hours. This results in a metal-organic protective agent complex (metal-amine complex when an amine is used as the organic protective agent).

Thermal decomposition

The thermal decomposition is a step of thermally decomposing the resulting metal-organic protective agent complex through the formation of the complex to form the surface-modified metal nanoparticles. It is believed that the metal-organic protective agent complex is heated to cause thermal decomposition of the metal compound to form metal atoms while maintaining coordination bonding of the organic protective agent to the metal atoms, and then agglomeration of the metal atoms to which the organic protective agent is coordinated, leading to formation of metal nanoparticles that are coated with an organic protective film.

The thermal decomposition is preferably performed in the presence of a reaction solvent, and the alcohol described above can be suitably used as the reaction solvent. In addition, the thermal decomposition temperature is to be a temperature at which the surface-modified metal nanoparticles are formed, and when the metal-organic protective agent complex is a silver oxalate-organic protective agent complex, the temperature is, for example, approximately from 80 to 120°C, preferably from 95 to 115°C, and particularly preferably from 100 to 110°C. In terms of preventing the elimination of the surface modification portion of the surface-modified metal nanoparticle, the thermal decomposition is preferably performed at a temperature as low as possible within the above temperature range. The thermal decomposition duration is, for example, approximately from 10 minutes to 5 hours.

In addition, the thermal decomposition of the metal-organic protective agent complex is preferably performed in an air atmosphere or in an inert gas atmosphere, such as argon.

Washing

The excess organic protective agent, if present after the completion of the thermal decomposition reaction of the metal-organic protective agent complex, is preferably removed by decantation, which may be repeated once or more times as necessary. In addition, the surface-modified metal nanoparticles after the completion of the decantation is preferably subjected to the preparation of the conductive ink described below in a wet state without drying or solidifying in that this can prevent re-agglomeration of the surface-modified metal nanoparticles and maintain high dispersibility.

Decantation is performed, for example, by washing the surface-modified metal nanoparticles in a suspended state with a cleaning agent, precipitating the surface-modified metal nanoparticles by centrifugation, and removing the supernatant. The cleaning agent used is preferably one or more types of linear or branched alcohols having from 1 to 4 (preferably from 1 to 2) carbon atoms, such as methanol, ethanol, n-propanol, or isopropanol in terms of achieving good precipitation of the surface-modified metal nanoparticles and efficiently separating and removing the cleaning agent by centrifugation after the washing.

Preparation of conductive ink

The preparation of the conductive ink is a step of mixing the surface-modified metal nanoparticles (preferably the surface-modified metal nanoparticles in a wet state) obtained through the above steps with the first ink resin and, as necessary, a dispersion medium, a binder resin (second ink resin), and any other additive and preparing the conductive ink according to an embodiment of the present disclosure. For the mixing, a commonly known mixing apparatus, such as, for example, a self-rotating stirring defoaming apparatus, a homogenizer, a planetary mixer, a three-roll mill, or a bead mill, can be used. In addition, each component may be mixed at the same time or sequentially. The mixing portion of each component can be appropriately adjusted in the range described below.

The content of the metal nanoparticles in the total amount (100 wt.%) of the conductive ink is, for example, from 60 to 85 wt.%, and the lower limit thereof is preferably 65 wt.% such that the effect of improving a steady contact to the substrate is obtained. The upper limit of the content is preferably 80 wt.% and particularly preferably 75 wt.%.

The content of the dispersion medium in the total amount (100 wt.%) of the conductive ink is, for example, from 5 to 50 wt.%, and the lower limit thereof is preferably 10 wt.%, and more preferably 20 wt.%. The upper limit of the content is preferably 45 wt.% and particularly preferably 40 wt.%. The dispersion medium contained in the above range can provide the effect of suppressing bleeding and improving the drawing accuracy of thin lines and the effect of improving the continuous printing properties.

The content of the dispersion medium in the conductive ink is, for example, from 30 to 60 parts by weight relative to 100 parts by weight of the metal nanoparticles, and the lower limit thereof is preferably 33 parts by weight, and more preferably 35 parts by weight. The upper limit of the content is preferably 55 parts by weight, and particularly preferably 50 parts by weight. The dispersion medium contained in the above range can provide the effect of suppressing bleeding and improving the drawing accuracy of thin lines and the effect of improving the continuous printing properties.

The content of the alcohol (b-1) (particularly, the monocyclic secondary alcohol) is, for example, from 15 to 70 parts by weight, preferably from 20 to 60 parts by weight, particularly preferably from 30 to 55 parts by weight, and most preferably from 35 to 55 parts by weight relative to 100 parts by weight of the metal nanoparticles.

The content of the hydrocarbon (b-2) (particularly, the aliphatic hydrocarbon) is, for example, from 5 to 50 parts by weight, preferably from 10 to 40 parts by weight, particularly preferably from 15 to 30 parts by weight, and most preferably from 15 to 28 parts by weight relative to 100 parts by weight of the metal nanoparticles.

A ratio between the contents of the alcohol (b-1) and the hydrocarbon (b-2) (the former/the latter (weight ratio)) in the total amount of the dispersion medium contained in the conductive ink is, for example, from 40/60 to 95/5, preferably from 45/55 to 90/10, and particularly preferably from 50/50 to 85/15. The content of the alcohol (b-1) falling below the above range would tend to reduce the smoothness of the coating film and additionally would tend to reduce the low-temperature sintering properties. On the other hand, the content of the hydrocarbon (b-2) falling below the above range would tend to reduce the applicability.

The content of the terpene solvent (b-3) in the total amount (100 wt.%) of the conductive ink is, for example, from 5 to 40 wt.%, and the lower limit thereof is preferably 10 wt.%, and more preferably 14 wt.%. The upper limit of the content is preferably 30 wt.% and more preferably 25 wt.%. The terpene solvent contained in the range described above can provide the effect of suppressing bleeding and improving the drawing accuracy of thin lines and the effect of improving the continuous printing properties.

The content of the terpene solvent (b-3) in the conductive ink is, for example, from 10 to 50 parts by weight relative to 100 parts by weight of the metal nanoparticles, and the lower limit thereof is preferably 15 parts by weight, and particularly preferably 20 parts by weight. The upper limit of the content is preferably 40 parts by weight and more preferably 35 parts by weight. The terpene solvent (b-3) contained in the above range can provide the effect of suppressing bleeding and improving the drawing accuracy of thin lines and the effect of improving the continuous printing properties.

The content of the glycol solvent (b-4) (in particular, the compound represented by Formula (b)) in the total amount (100 wt.%) of the conductive ink is, for example, from 1 to 15 wt.%, and the lower limit thereof is preferably 2 wt.% and more preferably 5 wt.%. The upper limit of the content is preferably 10 wt.% and more preferably 8 wt.%. The glycol solvent (b-4) (in particular, the compound represented by Formula (b)) contained in the above range can impart thixotropy, make the edge of a drawing part sharper, and improve the printing accuracy. In addition, the effect of improving continuous printing properties can also be obtained.

The content of the glycol solvent (b-4) (in particular, the compound represented by Formula (b)) in the conductive ink is, for example, 1 to 20 parts by weight relative to 100 parts by weight of the metal nanoparticles, and the lower limit thereof is preferably 2 parts by weight, and more preferably 5 parts by weight. The upper limit of the content is preferably 15 parts by weight and particularly preferably 12 parts by weight. The glycol solvent (b-4) (in particular, the compound represented by Formula (b)) contained in the above range can impart thixotropy, make the edge of the drawing part sharper, and improve the printing accuracy. In addition, the effect of improving continuous printing properties can also be obtained.

Additionally, the conductive ink can contain the compound represented by Formula (b') in an amount of 10 wt.% or less (from 5 to 10 wt.%), and preferably 8.5 wt.% or less of the total amount of the ink.

The ratio of the terpene solvent (b-3) to the glycol solvent (b-4) (terpene solvent (b-3)/glycol solvent (b-4)) in the conductive ink is, for example, from 0.1 to 10, and the lower limit thereof is preferably 1, more preferably 1.5, and more preferably 2. The upper limit of the ratio is preferably 5 and more preferably 4. The ratio of the terpene solvent (b-3) to the glycol solvent (b-4) adjusted to fall within the above range can provide the effect of improving the drawing accuracy of thin lines and the effect of improving the continuous printing properties, and make the edge of the drawing part sharper, and improve the printing accuracy. In addition, the effect of improving continuous printing properties can also be obtained.

The dispersion medium may contain one or two or more types of an additional dispersion medium, other than the alcohol (b-1), the hydrocarbon (b-2), the terpene solvent (b-3), and the glycol solvent (b-4). The total content of the alcohol (b-1), the hydrocarbon (b-2), the terpene solvent (b-3), and the glycol solvent (b-4) is 70 wt.% or greater, particularly preferably 75 wt.% or greater, and most preferably 80 wt.% or greater of the total amount of the dispersion medium. That is, the content of such an additional dispersion medium (total amount, if two or more types thereof are contained) is preferably 30 wt.% or less, particularly preferably 25 wt.% or less, and most preferably 20 wt.% or less of the total amount of the dispersion medium. When the content of such an additional dispersion medium exceeds the above range, the metal nanoparticles would tend to be prone to agglomeration and to be decreased in dispersibility.

Furthermore, the conductive ink may also contain a solvent having a boiling point of lower than 130°C [e.g., ethylene glycol dimethyl ether (boiling point: 85°C), propylene glycol monomethyl ether (boiling point: 120°C), propylene glycol dimethyl ether (boiling point: 97°C), or the like]. The content of the solvent having a boiling point of lower than 130°C (total amount, if two or more types thereof are contained) in the total amount (100 wt.%) of the conductive ink according to an embodiment of the present disclosure is preferably 20 wt.% or less, more preferably 10 wt.% or less, particularly preferably 5 wt.% or less, and most preferably 1 wt.% or less. In the conductive ink according to an embodiment of the present disclosure, the content of the solvent having a boiling point of lower than 130°C is suppressed to the range described above, thereby making it possible to suppress clogging caused by volatilization of the solvent and to perform continuous printing.

The content of the first ink resin in the total amount (100 wt.%) of the conductive ink according to an embodiment of the present disclosure is, for example, from 0.01 to 10 wt.%, and the lower limit thereof is preferably 0.05 wt.% and more preferably 0.07 wt.%. The upper limit of the content is preferably 5 wt.% and particularly preferably 3 wt.%. The first ink resin contained in the above range can improve the steady contact between the conductive layer and the overcoat layer while maintaining excellent electrical conductivity of the conductive layer. That is, the content of the first ink resin, which is 0.01 wt.% or greater, can improve the steady contact with the overcoat layer, and the content thereof, which is 10 wt.% or less, can maintain high electrical conductivity of the conductive layer.

The content of the first ink resin in the conductive ink according to an embodiment of the present disclosure is, for example, from 0.01 to 10 parts by weight relative to 100 parts by weight of the metal nanoparticles, and the lower limit thereof is preferably 0.05 parts by weight, and more preferably 0.1 parts by weight. The upper limit of the content is preferably 5 parts by weight, and particularly preferably 3 parts by weight. The first ink resin contained in the above range can improve the steady contact between the conductive layer and the overcoat layer while maintaining excellent electrical conductivity of the conductive layer. That is, the content of the first ink resin, which is 0.01 parts by weight or greater, can improve the steady contact with the overcoat layer, and the content thereof, which is 10 parts by weight or less, can maintain high electrical conductivity of the conductive layer.

The viscosity (at 25°C and a shear rate of 10 (1/s)) of the conductive ink according to an embodiment of the present disclosure is 60 Pa•s or greater, preferably 70 Pa•s or greater, more preferably 80 Pa•s or greater, even more preferably 90 Pa s or greater, even more preferably 100 Pa s or greater, and particularly preferably 150 Pa•s or greater. The upper limit of the viscosity is, for example, approximately 500 Pa•s, preferably 450 Pa•s, particularly preferably 400 Pa•s, and most preferably 350 Pa•s.

The viscosity (at 25°C and a shear rate of 100 (1/s)) of the conductive ink according to an embodiment of the present disclosure is, for example, from 10 to 100 Pa•s, and the upper limit thereof is preferably 80 Pa•s, particularly preferably 60 Pa•s, most preferably 50 Pa•s, and especially preferably 40 Pa•s. The lower limit of the viscosity is preferably 15 Pa•s, particularly preferably 20 Pa•s, most preferably 25 Pa•s, and especially preferably 30 Pa•s.

The conductive ink according to an embodiment of the present disclosure preferably has thixotropy, and a TI value at 25°C (viscosity at a shear rate of 10 (1/s)/viscosity at a shear rate of 100 (1/s)) thereof is in a range of for example from 3.0 to 10.0, preferably from 3.5 to 7.0, particularly preferably from 4.0 to 6.5, most preferably from 4.5 to 6.3, and especially preferably from 4.8 to 6.2.

The conductive ink according to an embodiment of the present disclosure is excellent in dispersion stability. For example, when a conductive ink having a silver concentration of 65 wt.% is stored at 5°C, an increase in viscosity can be suppressed over a period of 1 month or longer.

Overcoat layer-forming composition

The overcoat layer-forming composition according to an embodiment of the present disclosure contains an overcoat layer resin and an overcoat layer solvent having an SP value such that an absolute value of a difference between the SP value and an SP value of the first ink resin is 1.0 or less. In addition to these components, the overcoat layer-forming composition can contain an additive such as a surface energy adjusting agent, a plasticizer, a leveling agent, an antifoaming agent, and a silane coupling agent as necessary.

Overcoat layer resin

The overcoat layer resin according to an embodiment of the present disclosure is not particularly limited, as long as it has solubility in the overcoat layer solvent described below, and examples thereof include a thermoplastic resin and a heat or ultraviolet curable resin.

Examples of the thermoplastic resin include those exemplified as the first ink resin above.

Examples of the heat or ultraviolet curable resin include a curable epoxy resin, a curable acrylic resin, a curable polyester resin, a curable vinyl-based compound, a curable epoxy (meth)acrylate resin, and a photocurable urethane (meth)acrylate resin.

One overcoat layer resin can be included alone, or two or more overcoat layers can be included in combination. Furthermore, the overcoat layer resin may be identical with or different from the first ink resin.

The overcoat layer resin is preferably a thermoplastic resin from the perspective of storage stability, pot life, and the like, and examples thereof include a phenol resin, an acrylic resin, an alkyd resin, and a polyvinyl alcohol resin.

A content of the overcoat layer resin in a total amount (100 wt.%) of the overcoat layer-forming composition according to an embodiment of the present disclosure is, for example, from 1 to 30 wt.%, and the lower limit thereof is preferably 3 wt.%, and more preferably 5 wt.%. The upper limit of the content is preferably 25 wt.% and particularly preferably 15 wt.%. The overcoat layer resin included in the above range can improve the steady contact between the conductive layer and the overcoat layer. That is, the content of the overcoat layer resin, which is 1 wt.% or greater, can

improve the steady contact between the conductive layer and the overcoat layer, and the content thereof, which is 30 wt.% or less, can improve the coatability of the overcoat layer-forming composition.

Overcoat layer solvent

The overcoat layer solvent according to an embodiment of the present disclosure is a solvent having an SP value such that an absolute value of a difference between the SP value and an SP value of the first ink resin is 1.0 or less.
The overcoat layer solvent according to an embodiment of the present disclosure is not particularly limited, as long as it can dissolve the first ink resin described above, and examples thereof include n-pentane, gasoline, n-hexane, diethyl ether, n-octane, vinyl chloride monomer, cyclohexane, isobutyl acetate, isopropyl acetate, methyl isopropyl ketone, butyl acetate, carbon tetrachloride, methyl propyl ketone, ethylbenzene, xylene, toluene, ethyl acetate, tetrahydrofuran, benzene, trichloroethyl, methyl ethyl ketone, chloroform, methylene chloride, acetone, disulfide carbon, acetic acid, pyridine, n-hexanol, cyclohexanol, n-butanol, isopropyl alcohol, dimethylformamide, nitromethane, ethanol, methanol, ethylene glycol, glycerol, formamide, and diacetone alcohol.
The overcoat layer solvent in an embodiment of the present disclosure has an SP value of preferably approximately from 7 to 14, and more preferably approximately from 8 to 13, from the perspective of the dissolution of the first ink resin, the steady contact between the conductive layer and the substrate, and the like. Suitable specific examples of the overcoat layer solvent in an embodiment of the present disclosure include isopropyl alcohol (SP value: 11.5), butyl acetate (SP value: 8.5), propylene glycol monomethyl ether acetate (SP value: 8.7), xylene (SP value: 8.8), and ethyl acetate (SP value: 9.1).
In an embodiment of the present disclosure, a combination of the first ink resin and the overcoat layer solvent is not limited, as long as the absolute value of the difference between the SP values is 1.0 or less. Specific examples of the combination of the first ink resin and the overcoat layer solvent include polyester urethane and isopropyl alcohol (absolute value of the difference between their SP values: 0.5); and isoprene rubber and butyl acetate (absolute value of the difference between their SP values: 0.37); isoprene rubber and propylene glycol monomethyl ether acetate (absolute value of the difference between their SP values: 0.57); isoprene rubber and xylene (absolute value of the difference between their SP values: 0.67); and isoprene rubber and ethyl acetate (absolute value of the difference between their SP values: 0.97).
The content of the overcoat layer solvent in the total amount (100 wt.%) of the overcoat layer-forming composition according to an embodiment of the present disclosure is, for example, from 50 to 90 wt.%, and the lower limit thereof is preferably 60 wt.%, and more preferably 70 wt.%. The upper limit of the content is preferably 85 wt.% and particularly preferably 80 wt.%. The overcoat layer solvent contained in the above range can improve the steady contact between the conductive layer and the overcoat layer. That is, the content of the overcoat layer solvent, which is 50 wt.% or greater, can improve the steady contact with the overcoat layer, and the content thereof, which is 90 wt.% or less, can improve the coatability of the overcoat layer-forming composition.
The content of the overcoat layer solvent in the overcoat layer-forming composition according to an embodiment of the present disclosure is, for example, from 500 to 1000 parts by weight relative to 100 parts by weight of the first ink resin, and the lower limit thereof is preferably 550 parts by weight, and more preferably 600 parts by weight. The upper limit of the content is preferably 900 parts by weight, and particularly preferably 800 parts by weight. The overcoat layer solvent contained in the above range can improve the steady contact between the conductive layer and the overcoat layer. That is, the content of the overcoat layer solvent, which is 500 parts by weight or greater, can improve the steady contact between the conductive layer and the overcoat layer, and the content thereof, which is 1000 parts by weight or less, can improve the coatability of the overcoat layer-forming composition.
The overcoat layer-forming composition according to an embodiment of the present disclosure may contain such a solvent that an absolute value of a difference between an SP value of the solvent and an SP value of the overcoat layer resin is greater than 1.0, but, in terms of the steady contact between the conductive layer and the overcoat layer, the content of such a solvent is 20 wt.% or less, and preferably 15 wt.% or less of the total amount (100 wt.%) of the solvent.

Step A

In an embodiment of the present disclosure, Step A is a step of forming the conductive layer on the substrate using the conductive ink described above.
Step A preferably includes a step of applying the conductive ink onto the substrate by a printing method, and sintering the conductive ink.
The printing method is not particularly limited, and known printing methods such as inkjet printing, gravure printing, flexographic printing, and screen printing can be used without limitation.
A thickness of a coating film obtained by applying the conductive ink is preferably in a range such that a thickness of a sintered body obtained by sintering the coating film is, for example, from 0.1 to 5 μm (preferably, from 0.5 to 2 μm).

In Step A, when the conductive ink described above is used, sintering can be performed at low temperatures, and the sintering temperature is, for example, 130°C or lower (the lower limit of the sintering temperature is, for example, 60°C and is more preferably 100°C in that the sintering can be performed in a short period of time), and particularly preferably 120°C or lower. The sintering time is, for example, from 0.5 to 3 hours, preferably from 0.5 to 2 hours, and particularly preferably from 0.5 to 1 hour.

Using the conductive ink according to an embodiment of the present disclosure allows sintering of the metal nanoparticles to sufficiently proceed even through low-temperature sintering (e.g., sintering at low temperature and in a short period of time). As a result, a sintered body having excellent electrical conductivity, i.e., a volume resistivity of, for example, 25 μm or less, preferably 20 μm or less, and particularly preferably 15 μm cm or less. The conductivity (or volume resistivity) of the sintered body can be measured by the method described in Examples.

The use of the conductive ink according to an embodiment of the present disclosure, as described above makes it possible to form a sintered body having excellent steady contact even with a substrate having excellent solvent resistance and surface smoothness such as a glass substrate. For example, the coating film steady contact obtained by sintering performed on a glass sheet at 120°C for 30 minutes is 90% or greater, and preferably 95% or greater in a tape peeling test (according to JIS K 5600).

Step B

In an embodiment of the present disclosure, Step B is a step of forming the overcoat layer on the conductive layer using the above-described overcoat layer-forming composition.

Step B preferably includes a step of applying the overcoat layer-forming composition onto the conductive layer, followed by drying and/or curing.

A method of applying the overcoat layer-forming composition onto the conductive layer is not particularly limited, and examples thereof include dip coating, spin coating, flow coating, spray coating, roll coating, gravure roll coating, wire doctor coating, blade coating, air doctor coating, knife coating, reverse coating, kiss coating, cast coating, transfer roll coating, micro gravure coating, slot orifice coating, calender coating, and die coating.

A thickness of a coating film obtained by applying the overcoat layer-forming composition is preferably in a range such that a thickness of the overcoat layer after drying and/or curing is, for example, from 0.1 to 5 μm (preferably, from 0.5 to 2 μm).

Drying and/or curing conditions for the overcoat layer are also not particularly limited, and heating is preferably performed at from 60 to 200°C, and preferably from 90 to 150°C, for from 1 minute to 2 hours, and preferably from 15 minutes to 1 hour.

Furthermore, when the overcoat layer resin exhibits ultraviolet curability, ultraviolet light may be applied. A low-pressure mercury lamp, a medium-pressure mercury lamp, a high-pressure mercury lamp, a carbon arc lamp, a metal halide lamp, a xenon lamp, an electroless discharge tube, or the like can be used as a lamp emitting ultraviolet light. As a condition for ultraviolet light application, an amount of the ultraviolet light to be applied is normally from 100 to 1000 $mJ/cm^2$.

The method for manufacturing a conductive layer laminate according to an embodiment of the present disclosure can provide excellent steady contact between the conductive layer and the overcoat layer as described above. For example, the steady contact between the overcoat layer and the conductive layer of the conductive layer laminate obtained by heating and drying for 30 minutes at 130°C is 90% or greater, and preferably 95% or greater in the tape peeling test (according to JIS K 5600).

The method for manufacturing a conductive layer laminate according to an embodiment of the present disclosure may further include the following Step:
Step C: forming a hardcoat layer on the overcoat layer.

The formation of the hardcoat layer on the overcoat layer improves the scratch resistance and surface hardness of the conductive laminate and also improves the durability.

In Step C, a hardcoat layer can be formed, for example, by applying a hardcoating liquid onto the overcoat layer, and performing curing.

As the hardcoating liquid, known hardcoating liquids such as acrylic hardcoating liquids and silicone-based hardcoating liquids can be used without limitation.

A method for curing the coating film is not particularly limited, and, for example, can be performed similarly to the drying and/or curing conditions for the overcoat layer described above.

The method for manufacturing a conductive laminate according to an embodiment of the present disclosure can easily and inexpensively provide an electronic device having excellent steady contact between the conductive layer and the overcoat layer.

Electronic devices according to an embodiment of the present disclosure are suitably used, for example, in liquid crystal displays, organic EL displays, field emission displays (FED), IC cards, IC tags, solar cells, LED elements,

organic transistors, condensers (capacitors), electronic paper, flexible batteries, flexible sensors, membrane switches, touch screens, and EMI shields.

Each aspect disclosed in the present specification can be combined with any other feature disclosed herein.

## Examples

Hereinafter, although the invention of the present disclosure will be described in more detail by way of examples, each of the configurations, combinations thereof, and the like in each embodiment are an example, and various additions, omissions, substitutions, and other changes may be made as appropriate without departing from the spirit of the invention of the present disclosure. The present disclosure is not limited by the embodiments and is limited only by the claims.

### Example 1

#### Preparation of surface-modified silver nanoparticles (1)

Silver oxalate (molecular weight: 303.78) was obtained from silver nitrate (available from Wako Pure Chemical Industries, Ltd.) and oxalic acid dihydrate (available from Wako Pure Chemical Industries, Ltd.).

Then, 40.0 g (0.1317 mol) of the silver oxalate was charged to a 500-mL flask, 60 g of n-butanol was added to this, and an n-butanol slurry of silver oxalate was prepared. To this slurry, an amine mixed liquid of 115.58 g (1.5802 mol) of n-butylamine (molecular weight: 73.14, reagent available from Tokyo Chemical Industry Co., Ltd.), 51.06 g (0.3950 mol) of 2-ethylhexylamine (molecular weight: 129.25, reagent available from Wako Pure Chemical Industries, Ltd.), and 17.02 g (0.1317 mol) of n-octylamine (molecular weight: 129.25, reagent available from Tokyo Chemical Industry Co., Ltd.) was added dropwise at 30°C. After the dropwise addition, the mixture was stirred at 30°C for 1 hours to allow a complex forming reaction between silver oxalate and the amines to proceed. After the formation of the silver oxalate-amine complex, the silver oxalate-amine complex was thermally decomposed by heating at 110°C for 1 hour to obtain a dark blue suspension containing surface-modified silver nanoparticles.

The resulting suspension was cooled, and then 120 g of methanol (available from Wako Pure Chemical Industries, Ltd.) was added thereto and stirred. Then, the surface-modified silver nanoparticles were precipitated by centrifugation, and the supernatant was removed. To the surface-modified silver nanoparticles, 120 g of dipropylene glycol n-butyl ether (reagent available from Tokyo Chemical Industry Co., Ltd.) was added and stirred. Then, the surface-modified silver nanoparticles were precipitated by centrifugation, and the supernatant was removed. Surface-modified silver nanoparticles (1), in a wet state, containing dipropylene glycol n-butyl ether were thus obtained. The content of the surface-modified silver nanoparticles in the total amount (100 wt.%) of the wet-state surface-modified silver nanoparticles was 90 wt.%, from results of a thermal balance using TG/DTA 6300 available from SII. That is, the wet-state surface-modified silver nanoparticles contained 10 wt.% dipropylene glycol n-butyl ether.

The wet-state surface-modified silver nanoparticles (1) were observed using a scanning electron microscope (JSM-6700F available from JEOL Ltd.). Particle sizes of ten silver nanoparticles optionally selected in an SEM photograph were determined, and an average value thereof was defined as an average particle size. The average particle size (primary particle size) of the silver nanoparticle portion in the surface-modified silver nanoparticles was approximately 50 nm.

#### Preparation of silver ink

A liquid A was prepared by adding THA-70 (dispersion medium), EC300 (binder resin; second ink resin), and a polyester urethane resin (first ink resin) at a ratio shown in Table 1, stirring them for three hours with an oil bath (100 rpm), and then stirring and kneading (2 min × three times) the mixture with a rotation/revolution kneader (available from Kurabo Industries Ltd., Mazerustar KKK2508).

A black brown silver ink was obtained by adding the liquid A to the wet-state surface-modified silver nanoparticles (1) obtained above (containing 10 wt.% of dipropylene glycol n-butyl ether as the dispersion medium), and stirring (2 min × three times) and kneading them with the rotation/revolution kneader (available from Kurabo Industries Ltd., Mazerustar KKK2508).

The silver ink obtained above was applied to a polycarbonate substrate (trade name "PC1600", available from C.I. TAKIRON Corporation) to form a coating film. The formed coating film was sintered at 120°C for 30 minutes using a hot plate to obtain a conductive layer composed of a sintered body having a thickness of approximately 1 $\mu$m .

#### Preparation of overcoat layer-forming composition

75 parts by weight of propylene glycol monomethyl ether acetate (overcoat layer solvent), 15 parts by weight

of diacetone alcohol, and 10 parts by weight of a resol-type phenol resin (overcoat layer layer) were mixed and dissolved were mixed and dissolved to obtain an overcoat layer-forming composition.

The overcoat layer-forming composition was applied onto the conductive layer obtained above, left standing at room temperature for 10 minutes, and then dried in an oven at 130°C for 30 minutes to obtain a conductive laminate.

Examples 2 to 9 and Comparative Examples 1 to 4

Conductive laminates were obtained in the same manner as in Example 1 except that the formulations of the conductive ink and the overcoat layer-forming composition were changed as shown in Tables 1 and 2 below (unit: parts by weight).

The silver inks and conductive laminates obtained in the Examples and the Comparative Examples were evaluated by the following methods.

Evaluation of conductive layer steady contact of overcoat layer

A tape peeling test (according to JIS K 5600) was performed on the conductive laminates obtained in the Examples and the Comparative Examples. The proportion of the overcoat layer remaining on the conductive layer (residual rate: %) at the time of peeling the tape was calculated, and the substrate steady contact was evaluated based on the following criteria. The results are shown in Tables 1 and 2.

Evaluation Criteria

Good: The edges of the cuts were completely smooth, and there is no peeling at the lattice squares. (Classification 0)
Marginal: Small peeling of the coating film at the intersections of the cuts occurred. The affected cross-cut portions clearly do not exceed 5%. (Classification 1)
Poor: The coating film was peeled along the edges of the cuts, and/or at the intersections. The affected cross-cut portions clearly exceed 5%. (Classification 2 or higher)

Evaluation of electrical conductivity of sintered body

The silver inks obtained in the Examples and Comparative Examples were each applied onto a soda glass sheet to form a coating film. After the formation of the coating film, the coating film was rapidly sintered in an air drying furnace at 120°C for 30 minutes to obtain a sintered body having a thickness of approximately 4 μm. For the electrical conductivity of the obtained sintered body, the volume resistivity (μΩcm) thereof was measured using a four-terminal method (Loresta GP MCP-T610). The results are shown in Tables 1 and 2.

Viscosity

The viscosities of the silver inks obtained in the Examples and Comparative Examples were measured using a rheometer (trade name "Physica MCR301", available from Anton Paar) under conditions of 20°C and a shear rate of 10 (1/s). The results are shown in Tables 1 and 2.

[Table 1]

Table 1

| | | | Example 1 | Example 2 | Example 3 | Example 4 | Example 5 | Example 6 | Example 7 | Example 8 | Example 9 |
|---|---|---|---|---|---|---|---|---|---|---|---|
| Conductive ink | Surface-modified silver nanoparticles | Surface-modified silver nanoparticles | 69 | 69 | 69 | 69 | 69 | 69 | 69 | 69 | 69 |
| | Dispersion medium | Terusolve THA-70 | 21.88 | 21.88 | 21.88 | 21.88 | 21.88 | 21.88 | 21.88 | 21.88 | 21.88 |
| | | DPNB | 7.67 | 7.67 | 7.67 | 7.67 | 7.67 | 7.67 | 7.67 | 7.67 | 7.67 |
| | Binder resin | EC300 | 1.45 | 1.45 | 1.45 | 1.45 | 1.45 | 1.45 | 1.45 | 1.45 | 1.45 |
| | First ink resin | Polyester urethane (SP value = 12) | 1 | 0.5 | 0.1 | | | | | | 1 |
| | | Polymethyl methacrylate (SP value = 9.5) | | | | | | | | | |
| | | Polyvinyl acetate (SP value = 9.6) | | | | | | | | | |
| | | Isoprene rubber (SP value = 8.13) | | | | 1 | 1 | 1 | 1 | 1 | |
| Overcoat layer-forming composition<br>upper: overcoat layer resin<br>lower: overcoat layer solvent | | Phenol resin solution [IPA (SP value = 11.5), butyl acetate (SP value = 8.5)] | IPA | IPA | IPA | Butyl acetate | | | | | |
| | | Acrylic resin solution [PGMEA (SP value = 8.7)] | | | | | PGMEA | PGMEA | | | |
| | | Alkyd resin solution [xylene (SP value = 8.8), ethyl acetate (SP value = 9.1)] | | | | | | | Xylene | Ethyl acetate | |
| | | Polyvinyl alcohol solution [IPA (SP value = 11.5)] | | | | | | | | | IPA |

(continued)

| | | | Example 1 | Example 2 | Example 3 | Example 4 | Example 5 | Example 6 | Example 7 | Example 8 | Example 9 |
|---|---|---|---|---|---|---|---|---|---|---|---|
| Difference in SP value | | First ink resin - overcoat layer solvent | 0.50 | 0.50 | 0.50 | -0.37 | -0.57 | -0.57 | -0.67 | -0.97 | 0.50 |
| Evaluation Results | Adhesion | Cross-cut test JIS K5600-5-6 | Good | Good | Marginal | Good | Good | Good | Good | Good | Good |
| | Electrical conductivity | Volume resistivity (μΩcm) | 13 | 10 | 6.5 | 13 | 13 | 13 | 13 | 13 | 13 |
| | Viscosity | Pa•s (shear rate: 10 [1/s]) | 67 | 66 | 60 | 65 | 67 | 67 | 67 | 67 | 67 |

[Table 2]

(Table 2)

| | | | Comparative Example 1 | Comparative Example 2 | Comparative Example 3 | Comparative Example 4 |
|---|---|---|---|---|---|---|
| Conductive ink | Surface-modified silver nanoparticles | Surface-modified silver nanoparticles | 69 | 69 | 69 | 69 |
| | Dispersion medium | Terusolve THA-70 | 21.88 | 21.88 | 21.88 | 21.88 |
| | | DPNB | 7.67 | 7.67 | 7.67 | 7.67 |
| | Binder resin | EC300 | 1.45 | 1.45 | 1.45 | 1.45 |
| | First ink resin | Polyester urethane (SP value = 12) | | | | 1 |
| | | Polymethyl methacrylate (SP value = 9.5) | | 1 | | |
| | | Polyvinyl acetate (SP value = 9.6) | | | 1 | |
| | | Isoprene rubber (SP value = 8.13) | | | | |
| Overcoat layer-forming composition<br>upper: overcoat layer resin<br>lower: overcoat layer solvent | | Phenol resin solution [IPA (SP value = 11.5), butyl acetate (SP value = 8.5)] | IPA | IPA | IPA | Butyl acetate |
| | | Acrylic resin solution [PGMEA (SP value = 8.7)] | | | | |
| | | Alkyd resin solution [xylene (SP value = 8.8), ethyl acetate (SP value = 9.1)] | | | | |
| | | Polyvinyl alcohol solution [IPA (SP value = 11.5)] | | | | |
| Difference in SP value | | First ink resin - overcoat layer solvent | No resin | 2 | -1.9 | 3.5 |

(continued)

| | | | Comparative Example 1 | Comparative Example 2 | Comparative Example 3 | Comparative Example 4 |
|---|---|---|---|---|---|---|
| Evaluation Results | Adhesion | Cross-cut test JIS K5600-5-6 | Poor | Poor | Poor | Poor |
| | Electrical conductivity | Volume resistivity (μΩcm) | 6 | 12 | 11 | 13 |
| | Viscosity | Pa•s (shear rate: 10 [1/s]) | 60 | 64 | 64 | 63 |

From Tables 1 and 2, it can be seen that, when the difference between the SP values of the first ink resin and the overcoat layer solvent is 1.0 or less, the steady contact between the conductive layer and the overcoat layer is improved.

The components listed in the tables are as follows.

Surface-modified metal nanoparticles

- Surface-modified silver nanoparticles: surface-modified silver nanoparticles obtained in Preparation Example 1

Dispersion medium

- Terusolve THA-70: 4-(1'-acetoxy-1'-methylester)-cyclohexanol acetate, trade name: "Terusolve THA-70" available from NIPPON TERPENE CHEMICALS, INC., boiling point: 223°C, viscosity: 198 mPa•s
- DPNB: Dipropylene glycol n-butyl ether, trade name: "DOWANOL DPnB", available from The Dow Chemical Company

Binder resin

- EC 300: Ethylcellulose resin, trade name: "ETHOCEL std. 300 (ETHOCEL™, std. 300)", available from The Dow Chemical Company

First ink resin

- Polyester urethane (SP value = 12; trade name: SUNPRENE IB-129", available from Sanyo Chemical Industries, Ltd.)
- Polymethyl methacrylate (SP value = 9.5; trade name: "Poly(methyl methacrylate); weight average molecular weight: ~120,000", Sigma-Aldrich Co. LLC)
- Polyvinyl acetate (SP value = 9.6; trade name: "Poly(vinyl acetate); weight average molecular weight: ~100,000", Sigma-Aldrich Co. LLC)
- Isoprene rubber (SP value = 8.13; trade name: "LIR-30", available from

KURARAY CO.,LTD)

Overcoat layer resin

- Phenol resin (trade name: "J-325", available from DIC Corporation)
- Acrylic resin (trade name: "KC1300", available from KYOEISHA CHEMICAL CO., LTD.)
- Alkyd resin (trade name: "Alkydia P-794-55", available from DIC Corporation)
- Polyvinyl alcohol (trade name: "Poly(vinyl alcohol); weight average molecular weight: from 9,000 to 10,000", available from Sigma-Aldrich Co. LLC)

Overcoat layer solvent

- IPA (isopropanol, SP value = 11.5)
- Butyl acetate (SP value = 8.5)
- PGMEA (propylene glycol monomethyl ether acetate; SP value = 8.7)
- Xylene (SP value = 8.8)
- Ethyl acetate (SP value = 9.1)

Variations of embodiments of the present disclosure described above are additionally described below.

[1] A method for manufacturing a conductive laminate, the conductive laminate including a substrate, a conductive layer, and an overcoat layer being laminated, the method including the following Steps:

Step A: forming the conductive layer on the substrate using a conductive ink containing a metal nanoparticle and a first ink resin; and
Step B: forming the overcoat layer on the conductive layer using an overcoat layer-forming composition, the overcoat layer-forming composition containing an overcoat layer resin and an overcoat layer solvent, the overcoat layer solvent having an SP value, where a difference between the SP value and an SP value of the first ink resin is 1.0 or less in absolute value.

[2] The method for manufacturing a conductive laminate according to [1], wherein the difference between the SP value of the first ink resin and the SP value of the overcoat layer solvent in absolute value is 0.9 or less (preferably 0.8 or less, more preferably 0.7 or less, even more preferably 0.6 or less, even more preferably 0.5 or less, even more preferably 0.4 or less, even more preferably 0.3 or less, even more preferably 0.2 or less, and even more preferably 0.1 or less).
[3] The method for manufacturing a conductive laminate according to [1] or [2], wherein the SP values of the first ink resin and the overcoat layer solvent are SP values according to a Fedors method.
[4] The method for manufacturing a conductive laminate according to any one of [1] to [3], wherein the metal nanoparticle is a surface-modified metal nanoparticle having a configuration in which a surface of a metal nanoparticle is coated with an organic protective agent.
[5] The method for manufacturing a conductive laminate according to [4], wherein a proportion of the surface modification portion is from 1 to 20 wt.% (preferably from 1 to 10 wt.%) of the weight of a metal nanoparticle portion.
[6] The method for manufacturing a conductive laminate according to [4] or [5], wherein an average primary particle size of the metal nanoparticle portion is from 0.5 to 100 nm (preferably from 0.5 to 80 nm, more preferably from 1 to 70 nm, and even more preferably from 1 to 60 nm).
[7] The method for manufacturing a conductive laminate according to any one of [1] to [6], wherein the metal constituting the metal nanoparticle is at least one type (preferably, silver) selected from the group consisting of gold, silver, copper, nickel, aluminum, rhodium, cobalt, and ruthenium.
[8] The method for manufacturing a conductive laminate according to any one of [1] to [7], wherein the metal nanoparticle is a silver nanoparticle.
[9] The method for manufacturing a conductive laminate according to any one of [4] to [8], wherein the organic protective agent is a compound having at least one type of functional group (preferably, an amino group) selected from the group consisting of a carboxyl group, a hydroxyl group, an amino group, a sulfo group, and a thiol group.
[10] The method for manufacturing a conductive laminate according to any one of [4] to [9], wherein the organic protective agent is a compound having at least an amino group (preferably, a compound having from 4 to 18 carbon atoms and having an amino group).
[11] The method for manufacturing a conductive laminate according to any one of [1] to [10], wherein the first ink resin contains a thermoplastic resin.
[12] The method for manufacturing a conductive laminate according to any one of [1] to [11], wherein the SP value of the first ink resin is from 7 to 14 (preferably, from 8 to 13).

[13] The method for manufacturing a conductive laminate according to any one of [1] to [12], wherein the first ink resin is at least one type selected from the group consisting of isoprene rubber, polymethyl methacrylate, polyvinyl acetate, urethane rubber, polyethylene terephthalate, epoxy resin, polyester urethane, and polyvinyl alcohol.

[14] The method for manufacturing a conductive laminate according to any one of [1] to [13], wherein the conductive ink contains a dispersion medium.

[15] The method for manufacturing a conductive laminate according to [14], wherein the dispersion medium includes an alcohol (b-1) and/or a hydrocarbon (b-2).

[16] The method for manufacturing a conductive laminate according to [15], wherein the alcohol (b-1) includes an alicyclic secondary alcohol and/or an alicyclic tertiary alcohol.

[17] The method for manufacturing a conductive laminate according to [15] or [16], wherein the hydrocarbon (b-2) includes an aliphatic hydrocarbon (particularly preferably a chain aliphatic hydrocarbon, and most preferably a chain aliphatic hydrocarbon having 15 or more carbon atoms).

[18] The method for manufacturing a conductive laminate according to any one of [14] to [17], wherein the dispersion medium includes a terpene solvent (b-3) and/or a glycol solvent (b-4).

[19] The method for manufacturing a conductive laminate according to any one of [1] to [18], wherein the conductive ink further contains a binder resin.

[20] The method for manufacturing a conductive laminate according to [19], wherein the binder resin is at least one type (preferably, a cellulosic resin) selected from the group consisting of a vinyl chloride-vinyl acetate copolymer resin, a polyester resin, an acrylic resin, and a cellulosic resin.

[21] The method for manufacturing a conductive laminate according to [19] or [20], wherein a content of the binder resin is from 0.1 to 5.0 wt.% (preferably, from 0.5 to 3.0 wt.%) of a total amount of the conductive ink.

[22] The method for manufacturing a conductive laminate according to any one of [1] to [21], wherein a content of the metal nanoparticles in the total amount (100 wt.%) of the conductive ink is from 60 to 85 wt.% (a lower limit thereof is preferably 65 wt.%; and an upper limit thereof is preferably 80 wt.%, and particularly preferably 75 wt.%).

[23] The method for manufacturing a conductive laminate according to any one of [14] to [22], wherein a content of the dispersion medium in the total amount (100 wt.%) of the conductive ink is from 5 to 50 wt.% (a lower limit thereof is preferably 10 wt.%, and more preferably 20 wt.%; and an upper limit thereof is preferably 45 wt.%, and particularly preferably 40 wt.%).

[24] The method for manufacturing a conductive laminate according to any one of [14] to [23], wherein the content of the dispersion medium is from 30 to 60 parts by weight (a lower limit thereof is preferably 33 parts by weight, and more preferably 35 parts by weight, and an upper limit thereof is preferably 55 parts by weight, and particularly preferably 50 parts by weight) relative to 100 parts by weight of the metal nanoparticles.

[25] The method for manufacturing a conductive laminate according to any one of [1] to [24], wherein a content of the first ink resin in the conductive ink (100 wt.%) is from 0.01 to 10 wt.% (a lower limit thereof is preferably 0.05 wt.%, and more preferably 0.07 wt.%; and an upper limit thereof is preferably 5 wt.%, and particularly preferably 3 wt.%).

[26] The method for manufacturing a conductive laminate according to any one of [1] to [25], wherein the content of the first ink resin is from 0.01 to 10 parts by weight (a lower limit thereof is preferably 0.05 parts by weight, and more preferably 0.1 parts by weight, and an upper limit thereof is preferably 5 parts by weight, and particularly preferably 3 parts by weight) relative to 100 parts by weight of the metal nanoparticles.

[27] The method for manufacturing a conductive laminate according to any one of [1] to [26], wherein a viscosity at 25°C and a shear rate of 10 (1/s) of the conductive ink is 60 Pa•s (a lower limit thereof is preferably 70 Pa•s, more preferably 80 Pa•s, even more preferably 90 Pa•s, even more preferably 100 Pa•s, and particularly preferably 150 Pa•s; and an upper limit thereof is preferably approximately 500 Pa•s, more preferably 450 Pa•s, particularly preferably 400 Pa•s, and most preferably 350 Pa•s).

[28] The method for manufacturing a conductive laminate according to any one of [1] to [27], wherein a viscosity at 25°C and a shear rate of 100 (1/s) of the conductive ink is from 10 to 100 Pa•s (an upper limit thereof is preferably 80 Pa•s, particularly preferably 60 Pa•s, most preferably 50 Pa•s, and especially preferably 40 Pa•s; a lower limit thereof is preferably 15 Pa•s, particularly preferably 20 Pa•s, most preferably 25 Pa•s, and especially preferably 30 Pa•s).

[29] The method for manufacturing a conductive laminate according to any one of [1] to [28], wherein a TI value at 25°C (viscosity at a shear rate of 10 (1/s)/viscosity at a shear rate of 100 (1/s)) of the conductive ink is from 3.0 to 10.0 (preferably from 3.5 to 7.0, particularly preferably from 4.0 to 6.5, most preferably from 4.5 to 6.3, and especially preferably from 4.8 to 6.2).

[30] The method for manufacturing a conductive laminate according to any one of [1] to [29], wherein the overcoat layer resin includes at least one type (preferably, a thermoplastic resin) selected from the group consisting of a thermoplastic resin, a heat curable resin, and an ultraviolet curable resin.

[31] The method for manufacturing a conductive laminate according to any one of [1] to [30], wherein the overcoat

layer resin is at least one type selected from the group consisting of a phenol resin, an acrylic resin, an alkyd resin, and a polyvinyl alcohol resin.

[32] The method for manufacturing a conductive laminate according to any one of [1] to [31], wherein a content of the overcoat layer resin in a total amount (100 wt.%) of the overcoat layer-forming composition is from 1 to 30 wt.% (a lower limit thereof is preferably 3 wt.%, and more preferably 5 wt.%; and an upper limit thereof is preferably 25 wt.%, and particularly preferably 15 wt.%).

[33] The method for manufacturing a conductive laminate according to any one of [1] to [32], wherein the SP value of the overcoat layer solvent is from 7 to 14 (preferably, from 8 to 13).

[34] The method for manufacturing a conductive laminate according to any one of [1] to [33], wherein the overcoat layer solvent is at least one type selected from the group consisting of isopropyl alcohol, butyl acetate, propylene glycol monomethyl ether acetate, xylene, and ethyl acetate.

[35] The method for manufacturing a conductive laminate according to any one of [1] to [34], wherein a combination of the first ink resin and the overcoat layer solvent is polyester urethane and isopropyl alcohol (absolute value of the difference between their SP values: 0.5); and isoprene rubber and butyl acetate (absolute value of the difference between their SP values: 0.37); isoprene rubber and propylene glycol monomethyl ether acetate (absolute value of the difference between their SP values: 0.57); isoprene rubber and xylene (absolute value of the difference between their SP values: 0.67); and isoprene rubber and ethyl acetate (absolute value of the difference between their SP values: 0.97).

[36] The method for manufacturing a conductive laminate according to any one of [1] to [35],wherein a content of the overcoat layer solvent in the overcoat layer-forming composition is from 50 to 90 wt.% (a lower limit thereof is preferably 60 wt.%, and more preferably 70 wt.%; and an upper limit thereof is preferably 85 wt.%, and particularly preferably 80 wt.%).

[37] The method for manufacturing a conductive laminate according to any one of [1] to [36], wherein the content of the overcoat layer solvent is from 500 to 1000 parts by weight (a lower limit thereof is preferably 550 parts by weight, and more preferably 600 parts by weight, and an upper limit thereof is preferably 900 parts by weight, and particularly 800 parts by weight), relative to 100 parts by weight of the first ink resin.

[38] The method for manufacturing a conductive laminate according to any one of [1] to [37], wherein Step A includes applying the conductive ink onto the substrate by a printing method, and sintering the conductive ink.

[39] The method for manufacturing a conductive laminate according to [38], wherein the printing method is inkjet printing, gravure printing, flexographic printing, or screen printing

[40] The method for manufacturing a conductive laminate according to any one of [1] to [39], wherein Step B preferably includes applying the overcoat layer-forming composition onto the conductive layer, followed by drying and/or curing.

[41] The method for manufacturing a conductive laminate according to any one of [1] to [40], wherein a thickness of the overcoat layer is from 0.1 to 5 μm (preferably, from 0.5 to 2 μm).

[42] The method for manufacturing a conductive laminate according to any one of [1] to [41], wherein steady contact between the conductive layer and the overcoat layer is 90% or greater (preferably, 95% or greater) in a tape peeling test (according to JIS K 5600).

[43] The method for manufacturing a conductive laminate according to any one of [1] to [42], further including the following Step:

Step C: forming a hardcoat layer on the overcoat layer.

Industrial Applicability

An electronic device including the conductive laminate manufactured by the method of the present disclosure is less likely to cause a failure due to floating or peeling of the overcoat layer, and has excellent durability and quality.

Reference Signs List

10: Conductive laminate
11: Substrate
12: Conductive layer
13: Overcoat layer

## Claims

1. A method for manufacturing a conductive laminate, the conductive laminate comprising a substrate, a conductive layer, and an overcoat layer being laminated, the method comprising Steps below:

   Step A: forming the conductive layer on the substrate using a conductive ink comprising a metal nanoparticle and a first ink resin; and
   Step B: forming the overcoat layer on the conductive layer using an overcoat layer-forming composition, the overcoat layer-forming composition comprising an overcoat layer resin and an overcoat layer solvent, the overcoat layer solvent having an SP value, where a difference between the SP value and an SP value of the first ink resin is 1.0 or less in absolute value.

2. The method for manufacturing a conductive laminate according to claim 1, wherein the metal nanoparticle is a surface-modified metal nanoparticle having a configuration in which a surface of a metal nanoparticle is coated with an organic protective agent.

3. The method for manufacturing a conductive laminate according to claim 2, wherein the organic protective agent is a compound having at least one type of functional group selected from the group consisting of a carboxyl group, a hydroxyl group, an amino group, a sulfo group, and a thiol group.

4. The method for manufacturing a conductive laminate according to any one of claims 1 to 3, wherein the metal nanoparticle is a silver nanoparticle.

5. The method for manufacturing a conductive laminate according to any one of claims 1 to 4, wherein the conductive ink further comprises a binder resin.

6. The method for manufacturing a conductive laminate according to any one of claims 1 to 5, wherein a content of the first ink resin in the conductive ink is from 0.01 to 10 wt.%.

7. The method for manufacturing a conductive laminate according to any one of claims 1 to 6, wherein a content of the overcoat layer solvent in the overcoat layer-forming composition is from 50 to 90 wt.%.

8. The method for manufacturing a conductive laminate according to any one of claims 1 to 7, wherein the first ink resin comprises a thermoplastic resin.

9. The method for manufacturing a conductive laminate according to any one of claims 1 to 8, wherein the overcoat layer resin comprises at least one selected from the group consisting of a thermoplastic resin, a heat curable resin, and an ultraviolet curable resin.

10. The method for manufacturing a conductive laminate according to any one of claims 1 to 9, wherein Step A comprises applying the conductive ink onto the substrate by a printing method, and sintering the electrically conductive ink.

11. The method for manufacturing a conductive laminate according to any one of claims 1 to 10, further comprising Step below:
    Step C: forming a hardcoat layer on the overcoat layer.

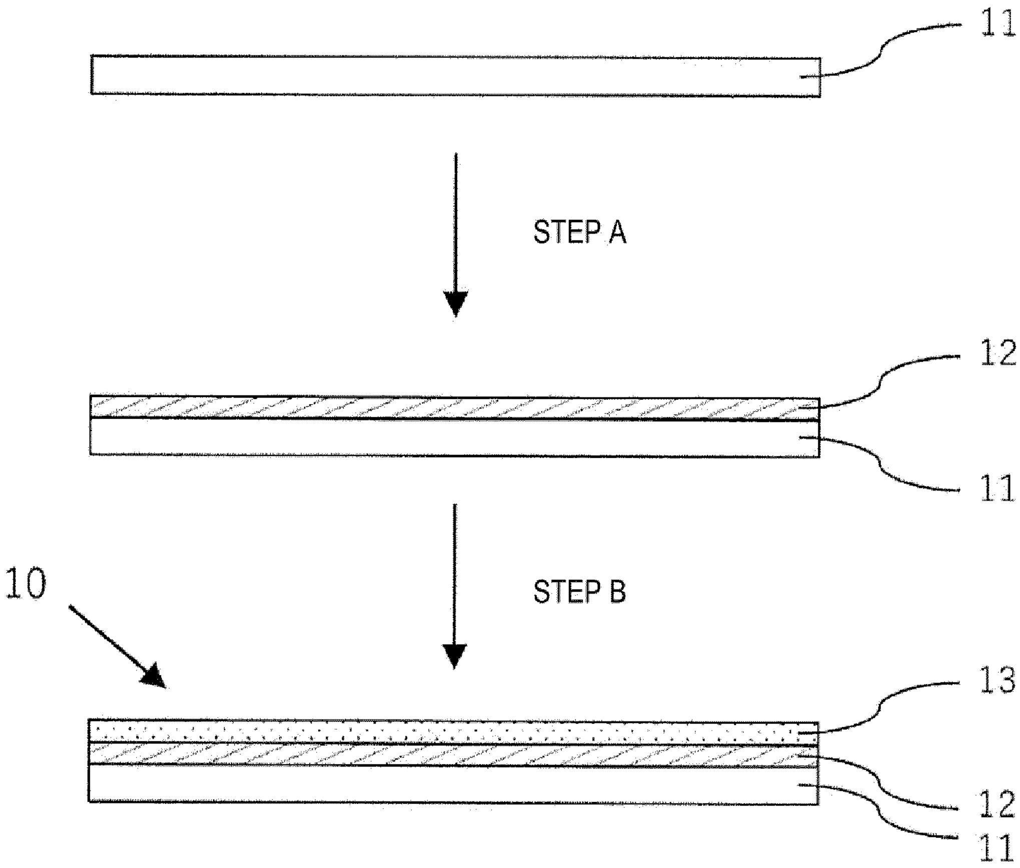


FIG. 1

## INTERNATIONAL SEARCH REPORT

International application No.
**PCT/JP2021/025307**

**A. CLASSIFICATION OF SUBJECT MATTER**

***B22F 1/02***(2006.01)i; ***B22F 7/04***(2006.01)i; ***B82Y 40/00***(2011.01)i; ***B33Y 10/00***(2015.01)i; ***H01B 13/00***(2006.01)i; ***B29C 64/112***(2017.01)i; ***H05K 1/09***(2006.01)i; ***H05K 3/10***(2006.01)i; ***H05K 3/12***(2006.01)i; ***H05K 3/28***(2006.01)i; ***B22F 3/16***(2006.01)i; ***B22F 1/00***(2006.01)i

FI: H05K3/28 C; H01B13/00 503D; H01B13/00 503Z; B22F1/02 B; B22F1/00 K; B22F3/16; B22F7/04 D; B82Y40/00; B33Y10/00; B29C64/112; H05K1/09 A; H05K3/12 610B; H05K3/12 630Z; H05K3/10 D

According to International Patent Classification (IPC) or to both national classification and IPC

**B. FIELDS SEARCHED**

Minimum documentation searched (classification system followed by classification symbols)

B22F1/00; B22F1/02; B22F7/04; B82Y40/00; B33Y10/00; H01B13/00; B29C64/112; H05K1/09; H05K3/10; H05K3/12; H05K3/28; B22F3/16

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2011-159922 A (NIPPON MEKTRON, LTD.) 18 August 2011 (2011-08-18) paragraphs [0028]-[0044], [0052]-[0054], fig. 2, 5 | 1-11 |
| Y | JP 2014-175187 A (DAINIPPON PRINTING CO., LTD.) 22 September 2014 (2014-09-22) paragraphs [0041]-[0042] | 1-11 |
| Y | JP 2018-199259 A (TOPPAN PRINTING CO., LTD.) 20 December 2018 (2018-12-20) paragraphs [0014], [0016] | 2, 3, 11 |
| Y | JP 2007-294996 A (TATSUTA SYSTEM ELECTRONICS KK) 08 November 2007 (2007-11-08) paragraph [0033], fig. 1(c) | 11 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **21 September 2021** | **05 October 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2021/025307**

| Patent document cited in search report | Publication date (day/month/year) | Patent family member(s) | Publication date (day/month/year) |
|---|---|---|---|
| JP 2011-159922 A | 18 August 2011 | US 2012/0103678 A1<br>paragraphs [0038]-[0054], [0062]-[0064], fig. 2, 5<br>WO 2011/096110 A1<br>CN 102598882 A | |
| JP 2014-175187 A | 22 September 2014 | (Family: none) | |
| JP 2018-199259 A | 20 December 2018 | (Family: none) | |
| JP 2007-294996 A | 08 November 2007 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2020118060 A
- WO 2014021270 A
- JP 2019098683 A
- JP 2020049813 A
- JP 2018206697 A

### Non-patent literature cited in the description

- **ROBERT F. FADORS et al.** *Polymer Engineering and Science,* vol. 14, 151-154